(19) Europäisches Patentamt
European Patent Office
Office européen des brevets

(11) **EP 2 103 718 A1**

(12) **EUROPEAN PATENT APPLICATION**
published in accordance with Art. 153(4) EPC

(43) Date of publication:
**23.09.2009 Bulletin 2009/39**

(51) Int Cl.:
*C25D 11/04* (2006.01)    *C25D 11/06* (2006.01)
*C25D 11/26* (2006.01)    *C25D 11/30* (2006.01)

(21) Application number: **07807134.7**

(22) Date of filing: **12.09.2007**

(86) International application number:
**PCT/JP2007/067727**

(87) International publication number:
**WO 2008/041455 (10.04.2008 Gazette 2008/15)**

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **28.09.2006 JP 2006264998**

(71) Applicant: **NIHON PARKERIZING CO., LTD.
Chuo-ku
Tokyo 103-0027 (JP)**

(72) Inventors:
• **YOSHIOKA, Nobuaki
Tokyo 103-0027 (JP)**

• **YAMASHITA, Masatoshi
Tokyo 103-0027 (JP)**
• **KONISHI, Tomoyoshi
Tokyo 103-0027 (JP)**

(74) Representative: **Albrecht, Thomas
Kraus & Weisert
Patent- und Rechtsanwälte
Thomas-Wimmer-Ring 15
80539 München (DE)**

(54) **METHOD FOR COATING CERAMIC FILM ON METAL, ELECTROLYSIS SOLUTION FOR USE IN THE METHOD, AND CERAMIC FILM AND METAL MATERIAL**

(57)    This invention provides a method for coating a ceramic film on a metal, which can form dense films on varisou bases of metals such as magnesium alloys. The formed ceramic film has excellent abrasion resistance, causes no significant attack against a counter material, and has excellent corrosion resistance. The method comprises electrolyzing a metallic base in an electrolysis solution using the metallic base as a working electrode while causing glow discharge and/or arc discharge on the surface of the metallic base to form a ceramic film on the surface of the metallic base. The electrolysis solution contains zirconium oxide particles having an average diameter of not more than 1 $\mu$m, satisfies the following formulae (1) to (3): 0.05 g/L $\leq$ X $\leq$ 500 g/L (1), 0 g/L $\leq$ Y $\leq$ 500 g/L (2), and 0 $\leq$ Y/X $\leq$ 10 (3); and has a pH value of not less than pH 7.0. In the formulae (1) to (3), X represents the content of zirconium oxide particles in the electrolysis solution; and Y represents the content of a compound of at least one element selected from the group consisting of Mg and the like, other than zirconium oxide.

EP 2 103 718 A1

**Description**

TECHNICAL FIELD

This invention relates to a method for coating a metal with a ceramic coating wherein the ceramic coating is formed on a metal substrate by electrolysis and an electrolyte adapted for use in such method for coating a metal with a ceramic coating. This invention also relates to a ceramic coating formed on a metal substrate and a metal material having such coating.

BACKGROUND ART

Various treatments such as anodizing, electroplating, and vapor deposition have been conducted to provide a hard coating or a corrosion resistant coating on a light metal material such as aluminum alloy and magnesium alloy. For example, surface treatment of an aluminum alloy has been conducted by forming a hard aluminum oxide coating by anodization using a sulfate bath at low temperature, or nickel or chromium plating.

In the case of magnesium alloy, the surface treatment by chemical conversion, nickel plating, or the like have failed to realize sufficient corrosion resistance since magnesium is the least noble metal of the metals used in practical level. Accordingly, anodizing using HAE, DOW17, or JIS bath has been conducted in the case of the magnesium alloy to thereby realize the sufficient corrosion resistance.

In the case of magnesium alloy, compact oxide coating can not be formed by magnesium itself since the volume reduces by the formation of oxide compared to the volume of the original metal as understood from volume fraction of Kubashevsky. Accordingly, the baths used for anodizing the magnesium alloy also contains compounds of chromium, fluorine, and the like. In the case when a compact hard coating is needed, use of an electrolyte containing a large amount of chromium compound such as DOW17 is usually required, and use of such electrolyte is unfavorable in view of environmental load and recyclability.

Patent Document 1 discloses a method for forming a coating on a magnesium alloy without using an electrolyte containing harmful substances such as heavy metal and fluorine. In this method, a corrosion resistant coating is formed on the magnesium alloy by conducting bipolar electrolysis using an alkaline electrolyte containing a large amount of sodium hydroxide and phosphoric acid.

Patent Document 2 discloses formation of a coating by anodizing using an electrolyte prepared by adding sodium metasilicate and an additive having sulfonate group.

These methods are capable of forming a coating having improved corrosion resistance and outer appearance on the magnesium alloy. However, these methods are incapable of forming a hard coating having improved chipping resistance and abrasion resistance.

Anodizing using an alkaline electrolyte usually results in the formation of an insulating film at a slow film formation speed. Patent Documents 3 and 4 disclose anodization of an aluminum alloy or magnesium alloy using an electrolyte having insoluble particles added thereto to thereby increase the file formation speed. More specifically, Patent Document 4 recommends adjustment of the concentration of the sodium metasilicate in the electrolyte in order to conduct anodizing with spark discharge.

These methods are capable of forming a thick coating having improved corrosion resistance, while they have been incapable of forming smooth coating having improved slidability.

In view of such situation, Anomag treatment has been proposed as a method for producing a coating having improved corrosion resistance and smoothness. In this method, anodizing is conducted by electrolysis associated with spark discharge.

In Non Patent Documents 1 and 2, formation of a highly corrosion resistant coating on a magnesium alloy has been realized by employing the Anomag treatment, and in this case, percentage of the corroded area after 1000 hours of salt spray test has been reported to be not more than 0.1%. While fine pores formed by the spark discharge during the electrolysis are observed in the coating, and the coating is porous, a compact transition layer of several micrometers is formed at the boundary between the matrix metal and the coating.

Patent Document 5 discloses a method for forming a smooth corrosion resistant coating without causing the spark discharge. The electrolyte used in this method contains ammonia as its main component, and the firing potential is thereby increased.

Patent Document 6 discloses a method in which a ceramic coating is formed on a magnesium alloy by spark discharge, and after adjusting the surface, the corrosion resistance is further improved by cation electrodeposition.

Patent Document 7 discloses a method for forming a ceramic coating in which a ceramic coating is formed on the surface of a substrate by spark discharge in an electrolyte. In this method, the spark discharge is caused while suspending ceramic fine particles in an aqueous solution containing water soluble or colloidal silicate and/or oxysalt.

[Patent Document 1] JP 2002-220697 A
[Patent Document 2] JP 2006-45624 A
[Patent Document 3] JP 8-167543 A
[Patent Document 4] JP 2004-91852 A
[Patent Document 5] JP 11-502567 A
[Patent Document 6] JP 2000-345370 A
[Patent Document 7] JP 3-94077 A
[Non Patent Document 1] Saijo, J., Hino, M., et al., Hyomen Gijutu (Surface Technology), 56(9), p. 547-551(2005)
[Non Patent Document 2] Sakai, K., Hino, M., et al., Materia, 43(1), p. 52-54 (2004)

DISCLOSURE OF THE INVENTION

PROBLEMS TO BE SOLVED BY THE INVENTION

However, in the surface treatment of the magnesium alloy described in Patent Documents 1 to 6 and Non Patent Documents 1 and 2, magnesium oxide is the main component of the coating, and this resulted in the low compactness and poor abrasion resistance. The coating also suffered from insufficient corrosion resistance.
In addition, with the recent improvement in casting technology such as thixomolding technology, magnesium alloy which is a light weight material with high specific strength is increasingly used for mechanical parts such as sliding member in addition to the use as a structural material. In connection with such situation, the coating formed by the method described in Patent Document 7 using the silicate is brittle and the coating also gives strong high attack to the counter member. The product is, therefore, unsuitable for application such as sliding member.
In view of such situation, an object of the present invention is to provide a method for forming a ceramic coating on a metal substrate comprising various metals such as magnesium alloy which is capable of forming a coating with high compactness, improved abrasion resistance, low attack on the counter member, and excellent corrosion resistance. Another object of the present invention is to provide an electrolyte use in such method, a ceramic coating, and a metal martial having such properties.

MEANS TO SOLVE THE PROBLEMS

The inventors of the present invention carried out an extensive investigation and found that, when the ceramic coating is formed on the surface of the metal substrate by conducing electrolysis in an electrolyte by causing glow discharge and/or arc discharge on the surface of a metal substrate which is used for the working electrode, and when the electrolyte contains a certain amount of zirconium oxide particles having an average particle size of up to 1 $\mu$m and the pH is at least 7.0, a compact ceramic coating having good abrasion resistance, low attack on the counter member, and high corrosion resistance can be formed even if the metal substrate was a magnesium alloy, and the resulting ceramic coating comprises a matrix layer comprising an amorphous oxide of the metal element constituting the metal substrate on which the coating is formed, and crystalline oxide of the metal element and zirconium oxide particles in the matrix layer, the zirconium oxide particles containing in at least a part thereof the metal element as solid solution. The present invention has been completed on the bases of such findings.
Accordingly, the present invention provides the following (1) to (30).

(1) A method for coating a metal with a ceramic coating comprising the step of causing glow discharge and/or arc discharge on a surface of a metal substrate which is used as a working electrode in an electrolyte to electrolytically form the ceramic coating on the surface of the metal substrate, wherein
the electrolyte contains zirconium oxide particles having an average particle size of up to 1 $\mu$m;
the electrolyte contains the zirconium oxide particles at a content of X and a compound other than the zirconium oxide which is a compound of at least one element selected from the group consisting of Mg, Al, Si, Ca, Sc, Ti, V, Cr, Mn, Fe, Co, Ni, Cu, Zn, Ga, Ge, Sr, Y, Zr, Nb, Mo, Tc, Ru, Rh, Pd, Ag, In, Sn, Ba, La, Hf, Ta, W, Re, Os, Ir, Pt, Au, Bi, Ce, Nd, Gd, and Ac at a content of Y, and the X and the Y satisfy the following relations (1) to (3) and the electrolyte has a pH of at least 7.0.

$$0.05 \ \mathrm{g/L} \ \leq \ X \ \leq \ 500 \ \mathrm{g/L} \qquad (1)$$

$$0 \text{ g/L} \leq Y \leq 500 \text{ g/L} \qquad (2)$$

$$0 \leq Y/X \leq 10 \qquad (3)$$

(2) The method for coating a metal with a ceramic coating according to (1) wherein the electrolyte contains titanium oxide particles having an average particle size of up to 1 $\mu$m.

(3) The method for coating a metal with a ceramic coating according to (1) or (2) wherein the zirconium oxide in the zirconium oxide particles has an amorphous and/or monoclinic crystal structure.

(4) The method for coating a metal with a ceramic coating according to any one of (1) to (3) wherein the electrolyte has an electric conductivity of at least 0.05 S/m.

(5) The method for coating a metal with a ceramic coating according to any one of (1) to (4) wherein the zirconium oxide particles in the electrolyte has a $\zeta$ potential of less than 0 mV.

(6) The method for coating a metal with a ceramic coating according to any one of (1) to (5) wherein the electrolyte contains a water-soluble phosphorus compound.

(7) The method for coating a metal with a ceramic coating according to any one of (1) to (6) wherein the electrolyte contains a water-soluble zirconium compound.

(8) The method for coating a metal with a ceramic coating according to any one of (1) to (7) wherein the electrolysis is conducted by unipolar electrolysis with anode polarization or bipolar electrolysis with anode polarization and cathode polarization.

(9) The method for coating a metal with a ceramic coating according to any one of (1) to (8) wherein the maximum voltage of the voltage waveform used in the electrolysis is at least 300V.

(10) The method for coating a metal with a ceramic coating according to (8) or (9) wherein the electrolysis causes change in the zirconium oxide crystal structure in the zirconium oxide particles, and this change results in the precipitation of the zirconium oxide in the ceramic coating.

(11) The method for coating a metal with a ceramic coating according to (10) wherein a part or all of the change in the crystal structure is the change from amorphous and/or monoclinic crystal structure to tetragonal crystal and/or cubic crystal structure.

(12) The method for coating a metal with a ceramic coating according to any one of (1) to (11) wherein the metal substrate comprises at least one member selected from the group consisting of aluminum, titanium, magnesium, and alloys thereof.

(13) An electrolyte for coating a metal with a ceramic coating,

the electrolyte containing zirconium oxide particles having an average particle size of up to 1 $\mu$m;
the electrolyte containing the zirconium oxide particles at a content of X and a compound other than the zirconium oxide which is a compound of at least one element selected from the group consisting of Mg, Al, Si, Ca, Sc, Ti, V, Cr, Mn, Fe, Co, Ni, Cu, Zn, Ga, Ge, Sr, Y, Zr, Nb, Mo, Tc, Ru, Rh, Pd, Ag, In, Sn, Ba, La, Hf, Ta, W, Re, Os, Ir, Pt, Au, Bi, Ce, Nd, Gd, and Ac at a content of Y, the X and the Y satisfying the following relations (1) to (3) and
the electrolyte having a pH of at least 7.0.
$$0.05 \text{ g/L} \leq X \leq 500 \text{ g/L} \qquad (1)$$

$$0 \text{ g/L} \leq Y \leq 500 \text{ g/L} \qquad (2)$$

$$0 \le Y/X \le 10 \qquad\qquad (3)$$

(14) The electrolyte for coating a metal with a ceramic coating according to (13), the electrolyte containing titanium oxide particles having an average particle size of up to 1 $\mu$m at a content of 0.04 to 400 g/L as titanium oxide.

(15) The electrolyte for coating a metal with a ceramic coating according to (13) or (14) wherein the zirconium oxide in the zirconium oxide particles has an amorphous and/or monoclinic crystal structure.

(16) The electrolyte for coating a metal with a ceramic coating according to any one of (13) to (15), the electrolyte having an electric conductivity of at least 0.05 S/m.

(17) The electrolyte for coating a metal with a ceramic coating according to any one of (13) to (16), wherein the zirconium oxide particles in the electrolyte has a $\zeta$ potential of less than 0 mV.

(18) The electrolyte for coating a metal with a ceramic coating according to any one of (13) to (17), the electrolyte containing a water-soluble phosphorus compound at a content of 0.005 to 150 g/L in terms of phosphorus.

(19) The electrolyte for coating a metal with a ceramic coating according to any one of (13) to (18), the electrolyte containing a water-soluble zirconium compound at a content of 0.1 to 100 g/L in terms of zirconium.

(20) The electrolyte for coating a metal with a ceramic coating according to any one of (13) to (19) which is used for forming a ceramic coating on a surface of a metal substrate comprising at least one member selected from the group consisting of aluminum, titanium, magnesium, and alloys thereof.

(21) A ceramic coating formed on a metal substrate, said ceramic coating comprising
a matrix layer comprising an amorphous oxide of the metal element constituting the metal substrate, and crystalline oxide of said metal element and zirconium oxide particles in the matrix layer, the zirconium oxide particles containing in at least a part thereof the metal element as solid solution.

(22) The ceramic coating according to (21) wherein the matrix layer contains titanium oxide particles having an average particle size of up to 1 $\mu$m.

(23) The ceramic coating according to (21) or (22) wherein concentration of the zirconium element gradually decreases from the side of said surface to the side of said metal substrate.

(24) The ceramic coating according to any one of (21) to (23) wherein the zirconium oxide in the zirconium oxide particles contains tetragonal and/or cubic crystal structure.

(25) The ceramic coating according to any one of (21) to (24) wherein relative intensity of the main peak of the tetragonal zirconium oxide and/or the cubic zirconium oxide is at least 1/4 of the relative intensity of the main peak of the oxide of the metal element, when the surface is analyized by X ray diffractometry.

(26) The ceramic coating according to any one of (21) to (25) wherein ratio of the volume of the monoclinic zirconium oxide to the total of the volume of the tetragonal zirconium oxide and/or the cubic zirconium oxide and the volume of the monoclinic zirconium oxide determined by X ray diffractometry of the surface is up to 0.8.

(27) The ceramic coating according to any one of (21) to (26) wherein ratio of content of the phosphorus compound per unit coating thickness in intermediate region other than surface region (the region from the surface to the depth of 1 $\mu$m) and boundary region (the region of 1 $\mu$m from the boundary with the metal substrate) to content of the phosphorus compound per unit coating thickness in the surface region and/or the boundary region is less than 1.

(28) The ceramic coating according to any one of (21) to (27) wherein the metal substrate comprises at least one member selected from the group consisting of aluminum, titanium, magnesium, and alloys thereof.

(29) The ceramic coating produced by the method for coating a metal with a ceramic coating of any one of (1) to (12).

(30) A metal material comprising a metal substrate and a ceramic coating on the metal substrate, wherein the ceramic coating is the ceramic coating of any one of (21) to (29).

EFFECTS OF THE INVENTION

The method for coating a metal with a ceramic coating of the present invention is capable of forming a compact coating on various metal substrates comprising various metals such as magnesium alloy, and the resulting coating has high abrasion resistance, low attack on the counter member, and excellent corrosion resistance.

BRIEF DESCRIPTION OF THE DRAWINGS

FIG. 1 is a cross sectional view schematically illustrating the ceramic coating of the present invention and the metal material of the present invention having such ceramic coating.

FIG. 2 shows the results of X-ray diffractometry for the zirconium oxide sol dispersed in water used for the electrolyte in Example 1.

FIG. 3(A) shows the results of monitoring the voltage and the current density during the electrolysis in Example 1.

FIG. 3(B) shows the results of monitoring the voltage and the current density during the electrolysis in Example 3.

FIG. 4 is a photograph taken by an optical microscope at a magnification of 1000 of the cross section of the coating obtained in Example 1.

FIG. 5(A) is a graph showing the results of the qualitative analysis by glow discharge optical emission spectrometry in depth direction for the coating obtained in Example 1, and FIG. 5(B) is a graph showing the results of the qualitative analysis by glow discharge optical emission spectrometry in depth direction for the coating obtained in Example 2.

FIGS. 6(A) to 6(D) are respectively graphs showing the pattern obtained in X-ray diffractometry in Examples 1, 2, and 13 and Comparative Example 1.

Explanation of reference numerals

10 Metal material
12 Ceramic coating
14 Metal substrate
16 Matrix layer
18 Crystalline oxide of the metal element
20 Zirconium oxide particles
20a Zirconium oxide particles not containing solid solution of the metal element constituting the metal substrate
20b Zirconium oxide particles containing the solid solution of the metal element constituting the metal substrate

BEST MODE FOR CARRYING OUT THE INVENTION

Next, the method for coating a metal with a ceramic coating, the electrolyte for use in such method, the ceramic coating, and the metal material according to the present invention are described. First, the method for coating a metal with a ceramic coating and the electrolyte for use in such method of the present invention are described.

The method for coating a metal with a ceramic coating (hereinafter also referred to as "the coating method of the present invention") comprises the step of causing glow discharge and/or arc discharge on a surface of a metal substrate which is used as a working electrode in an electrolyte to electrolytically form the ceramic coating on the surface of the metal substrate. In this method, the electrolyte contains zirconium oxide particles having an average particle size of up to 1 $\mu$m, and the electrolyte contains the zirconium oxide particles at a content of X and a compound other than the zirconium oxide which is a compound of at least one element selected from the group consisting of Mg, Al, Si, Ca, Sc, Ti, V, Cr, Mn, Fe, Co, Ni, Cu, Zn, Ga, Ge, Sr, Y, Zr, Nb, Mo, Tc, Ru, Rh, Pd, Ag, In, Sn, Ba, La, Hf, Ta, W, Re, Os, Ir, Pt, Au, Bi, Ce, Nd, Gd, and Ac at a content of Y, and the X and the Y satisfy the following relations (1) to (3):

$$0.05 \ g/L \ \leq \ X \ \leq \ 500 \ g/L \qquad (1),$$

$$0 \ g/L \ \leq \ Y \ \leq \ 500 \ g/L \qquad (2),$$

and

$$0 \ \leq \ Y/X \ \leq \ 10 \qquad (3).$$

The electrolyte has a pH of at least 7.0.

The metal substrate of the present invention is not particularly limited. The metal substrate, however, may preferably comprise a valve metal or its alloy. The valve metal or its alloy can be formed with an oxide coating by electrolytic treatment. Exemplary valve metals include aluminum, titanium, magnesium, niobium, and tantalum. Among these, the metal is preferably at least one member selected from aluminum, titanium, magnesium, and alloys thereof. When such metal is used for the metal substrate, the ceramic coating can be readily formed by unipolar electrolysis with anode polarization or bipolar electrolysis with anode polarization and cathode polarization.

In the present invention, the metal substrate is not limited to the case in which the entire substrate comprises the metal but also included is the case in which the metal is present as a plated coating or a vapor deposited coating.

The coating on the metal substrate may be formed without any pretreatment. However, in one preferred embodiment, the coating is preferably formed after cleaning the surface of the metal substrate by degreasing, etching, and the like.

The electrolyte used in the coating method of the present invention contains zirconium oxide particles having an average particle size of up to 1 $\mu$m.

When water soluble zirconium is used, formulation of the electrolyte is limited in various aspects since content of the water soluble zirconium affects electric conductivity of the electrolyte. In contrast, the coating method of the present invention has the merit that it uses zirconium oxide particles which does not affect the electric conductivity. In addition, use of the water soluble zirconium is also associated with the instability of the electrolyte at high pH region (for example, at a pH of 9 to 13) when the metal substrate comprises a magnesium alloy. In contrast, the coating method of the present invention uses zirconium oxide particles, and the electrolyte is also stable at a high pH.

Crystal structure of the zirconium oxide particles in the electrolyte is not particularly limited. The crystal structure is preferably amorphous and/or monoclinic. When the crystal structure is amorphous and/or monoclinic, industrial production can be readily accomplished compared to other crystal structures, and the electrolyte can be provided at a reduced cost.

The zirconium oxide particles have an average particle size (average crystal grain size) of up to 1 $\mu$m, preferably 0.001 to 0.5 $\mu$m, and more preferably 0.01 to 0.2 $\mu$m. When the average particle size is up to 1 $\mu$m, the resulting coating will have improved abrasion resistance, and the zirconium oxide particles in the electrolyte will be more resistant to precipitation. Use of the crystal particle having a crystal grain diameter of at least 0.001 $\mu$m can be produced at a reduced cost, and this in turn results in the production of the electrolyte of the present invention at a reduced cost.

Content X of the zirconium oxide particles in the electrolyte satisfies the relation (1), and X is in the range of 0.05 to 500 g/L. More preferably, X is in the range of 0.1 to .60 g/L, and most preferably 0.5 to 20 g/L. When the content X is within such range, the coating will be formed at a high speed, and the zirconium oxide particles will be less likely to experience aggregation or precipitation.

In one preferred embodiment, the electrolyte used in the coating method of the present invention contains a water soluble phosphorus compound. The water soluble phosphorus compound contributes for the reduction of the surface roughness of the coating by being adsorbed to and filling the defects on the surface of the metal substrate. This also contributes for the suppression of the leak current during the electrolysis even if the metal substrate contains Si and the metal substrate is a die cast plate in which current is likely to be collected to Si. The water soluble phosphorus compound also contributes for the stability of the electrolyte.

The water soluble phosphorus compound is not particularly limited, and exemplary water soluble phosphorus compounds include orthophosphoric acid and salts thereof, and condensed phosphoric acids such as pyrophosphoric acid and tripolyphosphoric acid and salts thereof. Among these, the preferred is orthophosphate salts such as diammonium hydrogenphosphate, dipotassium hydrogenphosphate, disodium hydrogenphosphate, dilithium hydrogenphosphate, ammonium dihydrogenphosphate, potassium dihydrogenphosphate, sodium dihydrogenphosphate, lithium dihydrogenphosphate, triammonium phosphate, tripotassium phosphate, trisodium phosphate, trilithium phosphate, and hydrates thereof. Use of an orthophosphate is preferred because the anion generated from the orthophosphate is adsorbed on the fine particles such as zirconium oxide particles in the electrolyte so that the fine particles exhibits negative C potential and the fine particles will be promoted to migrate toward the metal substrate which is being treated.

Content of the water soluble phosphorus compound in the electrolyte is preferably 0.005 to 150 g/L, and more preferably 0.1 to 10 g/L in terms of the phosphate. When the water soluble phosphorus compound is incorporated in such range, the electrolyte will have improved stability, and the excessive increase in the electric conductivity of the electrolyte is prevented, and this contributes for the reduction of the surface roughness of the coating formed.

The electrolyte used in the coating method of the present invention may contain a compound of at least one element selected from the group consisting of Mg, Al, Si, Ca, Sc, Ti, V, Cr, Mn, Fe, Co, Ni, Cu, Zn, Ga, Ge, Sr, Y, Zr, Nb, Mo, Tc, Ru, Rh, Pd, Ag, In, Sn, Ba, La, Hf, Ta, W, Re, Os, Ir, Pt, Au, Bi, Ce, Nd, Gd, and Ac except for zirconium oxide (hereinafter also referred to as the "particular compound").

Next, the particular compound is described by referring to examples.

In one preferred embodiment of the coating method of the present invention, the electrolyte contains titanium oxide particles as the particular compound. The titanium oxide particles which are eventually precipitated in the coating will facilitate control of various physical properties such as electric properties and heat dissipation properties.

The crystal structure of the titanium oxide particles in the electrolyte is not particularly limited. The crystal structure, however, is preferably at least one member selected from anatase, rutile, brookite, and amorphous structures.

The titanium oxide particles may preferably have an average particle size (average crystal grain size) of up to 1 $\mu$m, preferably 0.001 to 0.5 $\mu$m, and more preferably 0.01 to 0.2 $\mu$m. When the size is within such range, incorporation of the titanium oxide particles will not adversely affect the abrasion resistance or the corrosion resistance of the coating or the economical advantage.

The titanium oxide particles are preferably incorporated in the electrolyte at an amount of 0.04 to 400 g/L, and more preferably 0.08 to 40 g/L in terms of titanium oxide. When used at such content, the coating will be formed at a high speed, and the titanium oxide particles will be less likely to experience aggregation or precipitation.

In one preferred embodiment of the coating method of the present invention, the electrolyte contains water soluble zirconium compound as the particular compound. The water soluble zirconium compound will be incorporated in the coating as zirconium oxide, and prevents increase in the crystal grain size of the matrix oxide to thereby improve abrasion resistance of the coating.

The water soluble zirconium compound is not particularly limited, and examples include zirconium salts of an organic acid such as zirconium acetate, zirconium formate, zirconium lactate, and zirconium tartarate; zirconium complex salts such as ammonium zirconium carbonate, potassium zirconium carbonate, ammonium zirconium acetate, sodium zirconium oxalate, ammonium zirconium citrate, ammonium zirconium lactate, and ammonium zirconium glycolate.

Among these, the preferred are the zirconium carbonate compounds represented by the relation $M_2ZrO(CO_3)_2$ wherein M represents ammonium or alkali metal because such compounds dissolve in an alkaline electrolyte and exists in stable manner. Exemplary zirconium carbonate compounds include ammonium zirconium carbonate, and potassium zirconium carbonate.

The water soluble zirconium compound is preferably incorporated in the electrolyte at a content of 0.1 to 100 g/L, and more preferably at 0.5 to 50 g/L in terms of zirconium. Use of the water soluble zirconium compound in such content is preferable in view of improving abrasion resistance of the coating as well as high economical efficiency.

The water soluble zirconium compound is preferably incorporated in the electrolyte at a content of 0.01 to 10, and more preferably at 0.1 to 1 in relation to the content of the zirconium oxide particles. Use of the water soluble zirconium compound in such content is preferable in view of improving the abrasion resistance of the coating as well as prevention of excessively rough coating surface.

In one preferred embodiment of the coating method of the present invention, the electrolyte contains one member selected from the group consisting of yttrium compound, calcium compound, magnesium compound, scandium compound, cerium compound, and lanthanoid compound (for example, lanthanum compound, cerium compound, neodymium compound, and gadolinium compound) as the particular compound. When the electrolyte contains such compound, the coating will be provided with improved mechanical properties. In particular, when the electrolyte contains at least one member selected from yttrium compound, calcium compound, and cerium compound, partially stabilized zirconium will be formed, and this in turn results in the improved mechanical properties of the coating.

Exemplary yttrium compounds include yttrium nitrate and yttrium oxide, and exemplary calcium compounds include calcium tartarate and calcium oxide. Exemplary magnesium compounds include magnesium carbonate, magnesium phosphate, magnesium hydroxide, and magnesium oxide, and exemplary scandium compounds include scandium carbonate, scandium phosphate, and scandium oxide. Exemplary cerium compounds include cerium chloride, cerium hydroxide, cerium acetate, cerium carbonate, and cerium oxide.

More specifically, in one preferred embodiment of the present invention, the electrolyte contains at least one metal ion selected from yttrium, calcium, magnesium, scandium, and cerium and/or oxides thereof.

Such compound is preferably used at a content ratio of 0.001 to 0.3, and more preferably at 0.005 to 0.1 in relation to the zirconium compound.

In one preferred embodiment of the coating method of the present invention, the electrolyte contains a silicon compound as the particular compound. When the electrolyte contains a silicon compound, the surface of the coating will have a vitreous structure resulting in an improved slidability. Zirconium oxide has stress relaxation action, and the coating itself has excellent abrasion resistance, and incorporation of the silicon compound synergistically results in the excellent slidabilty. In this case, content of the silicon compound in terms of silicon is preferably 0.05 to 100 g/L, and more preferably 0.3 to 20 g/L.

On the other hand, absence of the silicon compound results in the excellent abrasion resistance with reduced attack on the counter member. Accordingly, in the coating method of the present invention, the electrolyte not containing the silicon compound as the particular compound is also a preferred embodiment.

Exemplary silicon compounds include silicon oxide, silicon nitride, silicon carbide, sodium silicate, hexafluorosodium silicate, tetramethoxysilane, $\gamma$- aminopropyltrimethoxysilane, and polymethylsiloxane.

In one preferred embodiment of the coating method of the present invention, the electrolyte contains a poorly soluble compound as the particular compound.

The poorly soluble compound is a compound which is poorly or non-soluble in water, and examples include oxide, hydroxide, phosphate, and carbonate of the elements as mentioned above. When the electrolyte contains such poorly soluble compound, the coating will be formed at a faster speed with no increase in the electric conductivity of the electrolyte, and this enables decrease in the time required for the electrolysis.

The examples of the poorly soluble compound other than the titanium oxide include iron oxide, bismuth oxide, hafnium oxide, tin oxide, silicon oxide (such as silica sol), cerium oxide, magnesium hydroxide, zirconium phosphate, titanium phosphate, calcium phosphate, zinc phosphate, manganese phosphate, and calcium carbonate.

Among these, the preferred is silicon oxide (silica sol), and the more preferred are a spherical silica, acicular silica, plate-shaped silica, and chain silica.

The poorly soluble compound may preferably have an average particle diameter of up to 1 $\mu$m, and more preferably up to 0.3 $\mu$m. Dispersion of the particles in the electrolyte is facilitated when the particle diameter is within such range.

Content of the poorly soluble particles in the electrolyte is not particularly limited. The content, however, is preferably in the range of 0.05 to 500 g/L, and more preferably 0.1 to 100 g/L.

In one preferred embodiment of the coating method of the present invention, the electrolyte contains a transition metal compound as the particular compound.

The transition metal compound is a compound of at least one transition metal compound selected from the group consisting of titanium, vanadium, manganese, iron, cobalt, nickel, copper, zinc, niobium, molybdenum, technetium, ruthenium, rhodium, silver, hafnium, tantalum, tungsten, rhenium, osmium, iridium, platinum, gold, and actinium.

Among these, the preferred are the compounds of the transition metal element which is a member of Group 4 to 8 (Groups IVA to VIIA and Group VIII) such as titanium, vanadium, manganese, iron, cobalt, nickel, molybdenum, and tungsten. The more preferred are compounds of molybdenum and tungsten.

When the electrolyte contains a transition metal element and the transition metal element is precipitated in the coating, the coating will have improved design freedom, lipophilicity, and heat resistance.

In addition, coefficient of thermal expansion of the ceramic coating will be reduced by the precipitation of a compound of molybdenum and/or tungsten, zirconium, and oxygen (for example zirconium tungstate having a negative coefficient of thermal expansion) in the ceramic coating.

Exemplary titanium compounds other than the titanium oxide and the titanium phosphate as described above include titanium potassium oxalate, titanium peroxide, titanium lactate, and iron titanium trioxide. Exemplary vanadium compounds include vanadium oxide, sodium vanadate, and ammonium vanadate. Exemplary manganese compounds include potassium permanganate, manganese dioxide, and manganese carbonate. Exemplary iron compounds include potassium ferrocyanide, potassium ferricyanide, lithium iron phosphate, ammonium iron citrate, and iron titanium trioxide. Exemplary cobalt compounds include cobalt carbonate, cobalt acetate, cobalt hydroxide, cobalt oxide, and lithium cobaltate. Exemplary nickel compounds include nickel hydroxide, nickel oxyhydroxide, nickel carbonate, and nickel acetate. Exemplary molybdenum compounds include sodium molybdate, ammonium molybdate, molybdenum trioxide, molybdenum disulfide, and ammonium thiomolybdate. Exemplary tungsten compounds include sodium tungstate, ammonium tungstate, tungsten trioxide, and zirconium tungstate.

Content of the transition metal compound in the electrolyte is preferably 0.01 to 500 g/L, and more preferably 0.1 to 50 g/L.

Content Y of the particular compound in the electrolyte satisfies the relation (2), and Y is in the range of 0 to 500 g/L. Accordingly, the electrolyte of the present invention may or may not contain the particular compound.

The content X of the zirconium oxide particles and the content Y of the particular compound in the electrolyte satisfy the relation (3), and Y/X is in the range of 0 to 10. When the Y/X is in such range, adverse effects associated with the incorporation of the particular compound, for example, the low abrasion resistance of the coating and excessive attack on the counter member of the coating in the case when the particular compound is silicon oxide can be suppressed. Y/X is preferably 0 to 1, and more preferably 0 to 0.25.

In one preferred embodiment of the coating method of the present invention, the electrolyte contains a peroxo compound as the particular compound. The peroxo compound has the effect of increasing the speed of the coating formation.

The peroxo compound is not particularly limited, and an example is hydrogen peroxide.

Preferably, the electrolyte contains the peroxo compound at 0.03 to 30 g/L.

In one preferred embodiment of the coating method of the present invention, the electrolyte contains an organic compound containing carboxy group and/or hydroxy group as the particular compound. When the electrolyte contains an organic compound containing carboxy group and/or hydroxy group, the zirconium oxide in the electrolyte will be provided with negative interfacial charge, and the electrolyte will have higher stability.

Examples of the organic compound containing carboxy group and/or hydroxy group include carbon black, phenol, polyvinyl alcohol, water soluble polyester resin, acrylic acid and its salt, polyacrylic acid and its salt, tartaric acid and its salt, malic acid and its salt, ascorbic acid and its salt, succinic acid and its salt, lactic acid and its salt, and adipic acid and its salt.

Content of the organic compound containing carboxy group and/or hydroxy group in the electrolyte is preferably 0.01 to 300 g/L, and more preferably 0.1 to 30 g/L. When incorporated at such content, the coating will have excellent abrasion resistance and the electrolyte will be highly stable.

The electrolyte used in the coating method of the present invention has a pH of at least 7.0, preferably at least 9.0, and more preferably at least 11, and the pH is also preferably less than 13.3. When the pH is within such range, the electrolyte will have high stability, high speed of coating formation, and reduced dissolution of the stainless steel plate used for the counter electrode.

The method used for adjusting the pH of the electrolyte to such range is not particularly limited. The pH, however, may be adjusted by incorporating an alkali metal ion and/or an ammonium ion in the electrolyte.

When an alkali metal ion is incorporated in the electrolyte, hydroxide of an alkaline metal such as sodium hydroxide, potassium hydroxide, or lithium hydroxide; alkaline metal salts including sodium salts such as a sodium silicate, a sodium phosphate, a sodium borate, or a sodium citrate and potassium salts such as a potassium silicate, a potassium phosphate, a potassium borate, and a potassium citrate may be incorporated in the electrolyte.

When an ammonium ion is incorporated in the electrolyte, ammonia; or an ammonium salt such as an ammonium silicate, an ammonium phosphate, an ammonium borate, or an ammonium citrate may be incorporated in the electrolyte.

Concentration of the alkali metal ion and/or the ammonium ion in the electrolyte is preferably 0.04 to 200 g/L, and more preferably 0.4 to 30 g/L. When the concentration of the alkali metal ion and/or the ammonium ion is within such range, the electrolyte will have high stability as well as good economy.

Alternatively, the electrolyte may be adjusted to such pH range by incorporating an organic alkali in the electrolyte.

Examples of the organic alkali include quaternary ammonium salts such as tetraalkylammonium hydroxide (for example, tetramethylammonium hydroxide) and trimethyl-2-hydroxyethylammonium hydroxide; and organic amines such as trimethylamine, alkanolamine, and ethylenediamine.

The electrolyte used in the coating method of the present invention may preferably have an electric conductivity of at least 0.05 S/m, more preferably at least 0.1 S/m, and most preferably at least 0.5 S/m. When the electric conductivity is within such range, the coating will be formed at a high speed. Also, the electrolyte used in the coating method of the present invention preferably has an electric conductivity of up to 20 S/m, and more preferably up to 5 S/m. Use of the electric conductivity within such range results in the reduced surface roughness of the resulting coating.

The method used for adjusting the electric conductivity of the electrolyte to such range is not particularly limited. An exemplary method is addition of an alkali metal salt such as potassium hydroxide, potassium carbonate, sodium hydroxide, sodium carbonate, sodium citrate, sodium tartarate, and potassium tartarate or an ammonium salt such as ammonium carbonate, triammonium phosphate, or ammonium dihydrogenphosphate.

In the electrolyte used in the coating method of the present invention, the zirconium oxide particles may preferably have a $\zeta$ potential of lower than 0 mV, and more preferably -10 mV or less. When the $\zeta$ potential is within such range, the fine particles are less likely to be aggregated or precipitated, and the electrolyte will have improved stability. Lower limit of the $\zeta$ potential is not particularly limited.

The $\zeta$ potential may be measured, for example, by laser Doppler method.

The electrolyte is not particularly limited for its production method, and the electrolyte may be produced by dissolving or dispersing the components as described above in a solvent. The solvent is preferably water while the solvent is not particularly limited.

In the coating method of the present invention, the ceramic coating is formed on the surface of the metal substrate by using the metal substrate for the working electrode and conducting electrolysis in the electrolyte as described above while inducing glow discharge and/or arc discharge (spark discharge) on the surface of the metal substrate.

The discharge state, namely, the state of glow discharge and/or the arc discharge on the surface of the metal substrate can be recognized by visually observing the surface of the metal substrate used for the working electrode. Glow discharge is a phenomenon in which the entire surface is surrounded by weak continuous glow, and arc discharge is a phenomenon in which intermittent spark is locally generated. Either one or both of the glow discharge and the arc discharge may take place on the surface.

The electrolysis is preferably conducted by unipolar electrolysis with anode polarization or by bipolar electrolysis with anode polarization and cathode polarization. The electrolysis can not be completed by unipolar electrolysis with only the cathode polarization because oxidation of the metal substrate is less likely to be induced by such electrolysis. When the bipolar electrolysis is used, the bipolar electrolysis used is preferably the one in which voltage value in the anode polarization is higher than the voltage value in the cathode polarization.

The method used for the electrolysis is not particularly limited, and exemplary methods used for the electrolysis include direct current electrolysis and pulse electrolysis. Among these, the preferred is the pulse electrolysis since the electrolysis is preferably conducted at a relatively high voltage as will be described below. The direct current electrolysis is economically disadvantageous since temperature of the electrolyte is easily increased.

In the bipolar electrolysis, the voltage waveform used may be the one comprising direct current component or alternate current component overlaid with at least one pulse wave selected from the group consisting of rectangular wave, sinusoidal wave, and triangular wave having a duty ratio of up to 0.5.

The conditions used in the electrolysis may be adequately selected depending on the metal and the electrolyte used in the electrolysis.

For example, when the electrolysis is conducted in the electrolyte by the bipolar electrolysis or the unipolar electrolysis by using a magnesium alloy for the working electrode, the maximum voltage (peak voltage) of the voltage waveform is preferably at least 300 V, and more preferably at least 400 V. When the maximum voltage is within such range, the glow discharge and/or the arc discharge can be easily generated. The maximum voltage of the waveform is preferably up to 800 V, and more preferably up to 700 V. When the maximum voltage is within such range, the surface roughness of the coating will not be excessive. With regard to the current density, the positive peak value is preferably at least 1 A/dm$^2$, and more preferably at least 20 A/dm$^2$ When the value is within such range, the coating will be formed at a high speed, and the metal substrate will be easily oxidized, and the weight of the zirconium oxide in the coating will also be increased. Also, the positive peak value of the current density is preferably up to 250 A/dm$^2$, and more preferably up to 150 A/dm$^2$. When the value is within such range, surface roughness of the coating can be sufficiently reduced.

By conducting electrolysis while causing the glow discharge and/or the arc discharge on the surface of the metal substrate, the ceramic coating is formed on the surface of the metal substrate. Since the electrolysis is conducted with the glow discharge and/or the arc discharge on the surface of the metal substrate, the components in the electrolyte are incorporated in the ceramic coating. In the course of this incorporation, the zirconium oxide in the zirconium oxide particles in the electrolyte preferably experiences change in the crystal structure, and as a result, the zirconium oxide precipitates in the ceramic coating.

The change is preferably such that a part or all of the change in the crystal structure is the one from amorphous and/or monoclinic structure to tetragonal and/or cubic structure.

For example, when a part or all of the crystal structure of the zirconium oxide in the zirconium oxide particles in the electrolyte is amorphous and/or monoclinic crystal which is the low temperature phase, tetragonal and/or cubic zirconium oxide which is the high temperature phase may be precipitated in the ceramic coating.

Tetragonal and/or cubic zirconium oxide has excellent mechanical properties and when present in the coating, it contributes for improvement in the abrasion resistance of the coating. The tetragonal and/or cubic zirconium oxide particles, however, are more expensive than amorphous and/or monoclinic zirconium oxide, and accordingly, it is preferable to change the crystal structure from the amorphous and/or monoclinic zirconium oxide to the tetragonal and/or cubic zirconium oxide for precipitation in the coating.

The electrolyte is not particularly limited for its temperature during the electrolysis, the electrolysis, however, is typically carried out at 3 to 50°C. The use of such temperature within such range is economically advantageous and dissolution of the metal substrate used for the work electrode will be reduced.

The electrolyte can be adjusted to such temperature, for example, by cooling the electrolyte.

The electrolysis may be conducted for any desired period in order to realize the desired coating thickness. The electrolysis, however, is generally conducted for 1 to 45 minutes, and more preferably for 5 to 30 minutes.

The apparatus used for the electrolysis is not particularly limited, and any apparatus known in the art may be used as desired.

The coating obtained by the coating method of the present invention is not particularly limited for its thickness, and any desired thickness may be selected depending on the intended use of the resulting article. The thickness, however, is preferably 0.01 to 500 μm, and more preferably 0.5 to 50 μm. When the thickness is in such range, the resulting coating will exhibit improved impact strength, and the time required for the electrolysis will not be excessively long to detract from the economic advantage.

In the coating method of the present invention, the ceramic coating is formed on the surface of the metal by the electrolysis as described above.

The mechanism by which the ceramic coating is formed is not fully clear. However, it is conceived that, when the anodized coating is formed on the surface of the metal substrate by the electrolysis, the zirconium oxide in the electrolyte undergoes change in the crystal structure to become incorporated in the coating to thereby form a combined coating of the oxide of the metal element used for the working electrode and the zirconium oxide.

This ceramic coating preferably contains tetragonal zirconium oxide and/or cubic zirconium oxide as in the case of the coating obtained in Examples 1, 2, and 13.

When a stress is applied to the tetragonal zirconium oxide (density, 6.10 g/cm$^3$), the tetragonal zirconium oxide typically undergoes change in its crystal structure to the monoclinic zirconium oxide (density, 5.56 g/cm$^3$) at the distal end of the crack for stress relaxation. Because of such mechanism, zirconium oxide exhibits high tenacity.

Cubic zirconium oxide is readily formed by incorporating the calcium oxide, the cerium oxide, or the yttrium oxide, and the stabilized zirconia and/or partly stabilized zirconia formed exhibits high tenacity.

Next, the ceramic coating and the metal material using such ceramic coating of the present invention are described.

The ceramic coating of the present invention is a ceramic coating formed on the metal substrate. The ceramic coating comprises a matrix layer comprising an amorphous oxide of the metal element constituting the metal substrate; and crystalline oxide of the metal element and zirconium oxide particles in the matrix layer. The zirconium oxide particles contain in at least a part thereof the metal element as solid solution. Such structure can be confirmed by preparing a thin section of the coating, and examining the section by transmission electron microscopy, electron diffractometry, energy dispersive X-ray spectrometry, or the like.

The metal material of the present invention is a metal material comprising a metal substrate and a ceramic coating on the metal substrate, and the ceramic coating is the ceramic coating of the present invention.

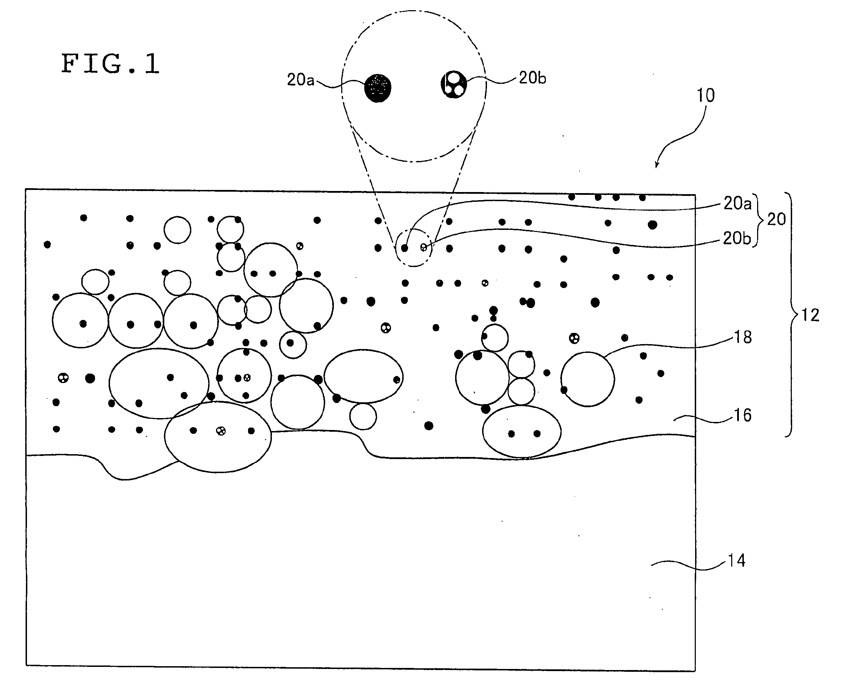

FIG. 1 is a schematic view showing the ceramic coating of the present invention and the metal material of the present invention having the ceramic coating formed thereon.

The metal material of the present invention 10 shown in FIG. 1 comprises a metal substrate 14 and a ceramic coating of the present invention 12 formed on the metal substrate 14. The ceramic coating 12 comprises a matrix layer 16 containing an amorphous oxide of the metal element constituting the metal substrate 14, and a crystalline oxide 18 of the metal element and zirconium oxide particles 20 included in the matrix layer 16.

In FIG. 1, the zirconium oxide particles 20 include zirconium oxide particles 20a free from the solid solution of the metal element constituting the metal substrate 14 and zirconium oxide particles 20b also containing the solid solution of the metal element constituting the metal substrate 14.

In the ceramic coating of the present invention, at least a part of the zirconium oxide particles 20 contain the solid solution of the metal element. Accordingly, the zirconium oxide particles 20 may solely comprise the zirconium oxide particles 20b with no zirconium oxide particles 20a. Alternatively, the number of the zirconium oxide particles 20b may be approximately 1/100 compared to the number of the zirconium oxide particles 20a.

In addition, as shown FIG. 1, the zirconium oxide particles 20 (the zirconium oxide particles 20a and/or the zirconium oxide particles 20b) may be present at the crystal grain boundary and/or in the crystal grain of the crystalline oxide 18.

The ceramic coating of the present invention will have improved abrasion resistance by the incorporation of the zirconium oxide particles 20 in the coating.

As described above, in the ceramic coating of the present invention, solid solution of the metal element is present in at least a part of the zirconium oxide particles 20, and this results in the deformation in the zirconium oxide crystal of the zirconium oxide particles 20b, and in turn, in the facilitation of oxide ion ($O^{2-}$) conduction. More specifically, the oxide ion conduction is greatly facilitated during the glow discharge and/or the arc discharge which is associated with local elevation of the temperature to 1000°C or higher. Accordingly, the oxide ion is likely to reach the boundary between the coating and the metal substrate, and this enables formation of compact coating structure with improved corrosion resistance and abrasion resistance.

The metal substrate 14 used in the metal material 10 of the present invention is the same as the metal substrate used in the coating method of the present invention.

In the ceramic coating 12 of the present invention, the crystalline oxide 18 of the metal element and zirconium oxide particles 20 are preferably present in dispersed state in the matrix layer 16 containing the amorphous oxide of the metal element constituting the metal substrate 14.

For example, when magnesium is the metal element constituting the metal substrate 14, namely, when the metal substrate 14 comprises magnesium or its alloy, the ceramic coating 12 may contain magnesium oxide (the amorphous oxide constituting the matrix layer 16 and the crystalline oxide 18) and zirconium oxide particles 20.

The matrix layer 16 may also contain elements other than the metal element constituting the metal substrate 14, and such element may be present as a compound of such element. Exemplary such compounds include phosphorus compounds such as magnesium phosphate and aluminum phosphate.

In addition, matrix layer 16 does not contain the zirconium oxide from the zirconium oxide particles in the electrolyte (except for the case when the electrolyte also contains water soluble zirconium). In other words, the zirconium oxide particles 20 are present only in the form of particles.

The zirconium oxide particles in the ceramic coating has an average particle size of preferably up to 1 $\mu$m, more preferably 0.001 to 0.5 $\mu$m, and still more preferably 0.01 to 0.2 $\mu$m. When the average particle size is within such range, the coating will be provided with excellent hardness and abrasion resistance. The coating will also exhibit reduced attack on the counter member upon sliding.

Shape of the zirconium oxide particles in the ceramic coating is not particularly limited, and exemplary shapes include sphere, needle, and plate shapes. When the zirconium oxide particles are not spherical, the minor diameter is preferably in the range of 0.001 to 0.25 $\mu$m, and the major diameter is preferably in the range of 0.01 to 0.5 $\mu$m.

Content of the zirconium oxide particles in the ceramic coating is not particularly limited. The content, however, is preferably at least 1, and more preferably 10 to 50000 particles per 10 $\mu$m$^3$ of the composite ceramic coating.

Crystal structure of the zirconium oxide particles in the ceramic coating is not particularly limited. The crystal structure, however, is preferably tetragonal and/or cubic as will be described below. In this case, the zirconium oxide particles may preferably have an average particle size of 0.001 to 0.5 $\mu$m.

When the zirconium oxide particles in the ceramic coating has tetragonal and/or cubic crystal structure which has improved mechanical properties, stress relaxation action will be generated against mechanical deformation and heat, and the ceramic coating will exhibit excellent abrasion resistance and heat resistance.

In one preferred embodiment of the ceramic coating of the present invention, the matrix layer 16 contains titanium oxide particles. Incorporation of the titanium oxide particles in the ceramic coating facilitates control of various physical properties of the coating such as electric properties and heat dissipation properties.

The crystal structure of the titanium oxide particles in the ceramic coating is not particularly limited. The crystal structure, however, is preferably at least one member selected from anatase, rutile, brookite, and amorphous structures.

The titanium oxide particles in the ceramic coating may preferably have an average particle size (average crystal grain size) of up to 1 $\mu$m, preferably 0.001 to 0.5 $\mu$m, and more preferably 0.01 to 0.2 $\mu$m. When the size is within such range, incorporation of the titanium oxide particles will not adversely affect the abrasion resistance or the corrosion resistance of the coating or the economical advantage.

Content of the titanium oxide particles in terms of $TiO_2$ in the ceramic coating is preferably up to 25% by weight, and more preferably 0.1 to 10% by weight in relation to the entire ceramic coating. When the content is within such range, various physical properties can be controlled without detracting from the abrasion resistance and corrosion resistance of the coating.

In one preferred embodiment of the ceramic coating of the present invention, the ceramic coating contains a phosphorus compound. Incorporation of a phosphorus compound in the ceramic coating contributes for the improved initial slidability.

The phosphorus compound in the ceramic coating may be either crystalline or amorphous.

Exemplary phosphorus compounds include phosphorus oxides such as diphosphorus pentoxide; phosphates such as zirconium phosphate, potassium zirconium phosphate, sodium zirconium phosphate, zirconium silicophosphate, aluminum phosphate, titanium phosphate, magnesium phosphate, sodium phosphate, and cerium phosphate; polyphosphate such as zirconium pyrophosphate, aluminum pyrophosphate, calcium pyrophosphate, zirconium polyphosphate, and aluminum tripolyphosphate. Among these, the preferred is phosphorus oxides.

Content of the phosphorus compound in terms of $P_2O_5$ in the ceramic coating is preferably up to 25% by weight, and more preferably 0.1 to 5% by weight in relation to the entire coating. When the content is within such range, the coating will have improved slidability as well as reduced surface roughness.

Location of the phosphorus compound in the ceramic coating is not particularly limited. The phosphorus compound, however, is preferably abundant at the boundary between the ceramic coating 12 and the metal substrate 14 and/or on the surface of the ceramic coating 12. When the phosphorus compound is abundant at the boundary between the ceramic coating 12 and the metal substrate 14, formation of voids at the boundary between the ceramic coating 12 and the metal substrate 14 will be suppressed, and the coating will have improved corrosion resistance. When the phosphorus compound is abundant on the surface of the ceramic coating 12, the coating will exhibit improved slidability. More specifically, ratio of the content of the phosphorus compound per unit coating thickness in the intermediate region other than the surface region (the region from the surface to the depth of 1 $\mu$m) and the boundary region (the region of 1 $\mu$m from the boundary with the metal substrate 14) to the content of the phosphorus compound per unit coating thickness in surface region and/or the boundary region is less than 1, and more preferably up to 0.99.

In one preferred embodiment of the ceramic coating of the present invention, the ceramic coating contains at least one element selected from the group consisting of yttrium, calcium, cerium, scandium, and magnesium. More specifically, such element is preferably incorporated in and/or near the zirconium oxide particles. Of the zirconium oxide crystal structures of the zirconium oxide particles, this element has the effect of stabilizing tetragonal and/or cubic crystals. The compound of such element in the ceramic coating may be either crystalline or amorphous.

Exemplary compounds of such element include yttrium oxide, yttrium zirconate, and yttrium phosphate; calcium oxide, calcium zirconate, and calcium phosphate; cerium oxide and cerium phosphate; scandium oxide; and magnesium oxide, magnesium zirconate, and magnesium phosphate. Among these, the preferred are oxides (such as yttrium oxide, calcium oxide, cerium oxide, scandium oxide, and magnesium oxide).

Content of such element in the ceramic coating is preferably up to 0.3 in relation to the zirconium content.

The ceramic coating according to a preferred embodiment of the present invention contains a transition metal compound.

The transition metal compound is preferably a compound of at least one transition metal element selected from the group consisting of titanium, vanadium, manganese, iron, cobalt, nickel, copper, zinc, niobium, molybdenum, technetium, ruthenium, rhodium, silver, hafnium, tantalum, tungsten, rhenium, osmium, iridium, platinum, gold, and actinium.

Among these, the preferred are the compounds of the transition metal element which is a member of Group 4 to 8 (Groups IVA to VIIA and Group VIII) such as titanium, vanadium, manganese, iron, cobalt, nickel, molybdenum, and tungsten. The more preferred are compounds of molybdenum and tungsten.

When the ceramic coating contains a transition metal element, the coating will have improved design freedom, lipophilicity, and heat resistance.

In addition, coefficient of thermal expansion of the ceramic coating will be reduced by the precipitation of a compound of molybdenum and/or tungsten, zirconium, and oxygen (for example zirconium tungstate having a negative coefficient of thermal expansion) in the ceramic coating.

Exemplary titanium compounds include iron titanium trioxide in addition to the titanium oxide and the titanium phosphate as mentioned above. Exemplary vanadium compounds include vanadium oxide and vanadium phosphate. Exemplary manganese compounds include manganese dioxide and manganese phosphate. Exemplary iron compounds include lithium iron phosphate, triiron tetroxide, iron sesquioxide, and iron phosphate. Exemplary cobalt compounds include cobalt phosphate, cobalt oxide, and lithium cobaltate. Exemplary nickel compounds include nickel phosphate and nickel oxide. Exemplary molybdenum compounds include molybdenum phosphate, molybdenum trioxide, and zirconium molybdate. Exemplary tungsten compounds include tungsten trioxide and zirconium tungstate.

Content of the transition metal compound in the ceramic coating is preferably in the range of up to 0.8, and more preferably in the range of 0.01 to 0.1 in terms of the transition metal element in relation to the content of the zirconium.

In one preferred embodiment of the ceramic coating of the present invention, concentration of the zirconium element gradually decreases from the side of said surface to the side of said metal substrate. Abrupt change in the physical properties at the boundary between the ceramic coating and the metal substrate invites concentration of the stress to the boundary, which in turn results in peeling, fracture, and the like. In contrast, concentration profile as described above prevents peeling, fracture, and the like.

In one preferred embodiment of the ceramic coating of the present invention, the zirconium oxide particles preferably have zirconium oxide crystal structure including tetragonal and/or cubic crystal structures.

More specifically, in the ceramic coating of the present invention according to one preferred embodiment, relative intensity of the main peak of the tetragonal zirconium oxide and/or the cubic zirconium oxide is at least 1/4 of the relative intensity of the main peak of the oxide of the metal element constituting the metal substrate. In a more preferred embodiment, this ratio is at least 1. In this embodiment, the zirconium oxide in the zirconium oxide particles will have sufficiently high degree of crystallization, and the ceramic coating will have improved impact strength and abrasion resistance.

The X ray diffractometry may be carried out by thin film method.

In one preferred embodiment, the surface of the ceramic coating of the present invention has proportion of the volume of the monoclinic zirconium oxide in the total of the volume of the tetragonal zirconium oxide and/or the cubic zirconium oxide and the volume of the monoclinic zirconium oxide ($V_m$) as examined by X-ray diffractometry of up to 0.8. In more preferred embodiment, Vm is up to 0.5. When Vm is within such range, loss of stress relaxation action by the monoclinic zirconium oxide under stress will be reduced, and the ceramic coating will exhibit improved impact strength and abrasion resistance.

The X ray diffractometry may be carried out by thin film method.

$V_m$ is calculated by using the intensity measured in the X ray diffractometry using the following relation (4):

$$V_m = \{I(-111)_m + I(111)_m\} / \{I(-111)_m + I(111)_m + I(111)_{tc}\} \quad (4)$$

$V_m$: proportion of the volume of the monoclinic zirconium oxide in the total of the volume of the tetragonal zirconium oxide and/or the cubic zirconium oxide and the volume of the monoclinic zirconium oxide.

$I(111)_{tc}$: relative intensity of the peak in (111) face of the tetragonal zirconium oxide and/or the cubic zirconium oxide.

$I(-111)_m$: relative intensity of the peak in (-111) face of the monoclinic zirconium oxide.

$I(111)_m$: relative intensity of the peak in (111) face of the monoclinic zirconium oxide.

Differentiation of the peak in (111) face of the tetragonal zirconium oxide from the peak in (111) face of the cubic zirconium oxide is difficult, and in the present invention, these peaks are used as as $I(111)_{tc}$ without differentiating one from the other.

The ceramic coating of the present invention is not particularly limited for its thickness, and the thickness may be adequately selected depending on the intended use. The ceramic coating typically has a thickness of 0.01 to 500 $\mu$m, and more preferably 0.5 to 50 $\mu$m. When the thickness is within such range, the coating will be provided with improved impact strength, and the time required for the electrolysis will not be too long to detract from economic advantage.

The ceramic coating of the present invention may preferably have a center line average roughness of the surface of 0.001 to 10 $\mu$m, and more preferably 0.1 to 3 $\mu$m. When the surface roughness is within such range, the coating will have good oil retaining ability, and attack on the counter member will be reduced due to the inexcessive surface roughness.

The ceramic coating of the present invention and the metal material having such ceramic coating of the present invention are not particularly limited for their production method. They can be produced, for example, by an electrolysis such as bipolar or unipolar electrolysis using the metal substrate for the working electrode. The ceramic coating and the metal material are preferably produced by the coating method of the present invention.

Before the electrolysis, the metal substrate may be degreased for removal of the oil components from the surface of the metal substrate. Alternatively, the metal substrate may be pickled for removing the oxide film that had been formed on the metal substrate.

The electrolysis may be conducted by using a high voltage of 300 V or higher with glow discharge and/or arc discharge (spark discharge).

During the discharge, the surface of the metal substrate temporarily experiences local melting and solidification and this contributes for the hardening of the surface. The surface is said to experience the melting at a temperature of 1000°C or higher, and the quenching by the electrolyte while intaking the oxygen generated by the working electrode is one factor which is postulated to contribute for the hardening of the surface.

The electrolysis is preferably accomplished by pulse electrolysis because it generates high current density during the discharge. Use of direct current voltage is unfavorable since the excessively high current density may easily result in the boiling of the electrolyte and such boiling is likely to invite void formation in the composite ceramic coating. The current density is preferably 1 to 250 A/dm$^2$ and more preferably 20 to 150 A/dm$^2$ at the peak. When the current density is within such range, the ceramic coating is formed at a sufficiently high speed, and incorporation of the zirconium oxide in the coating is facilitated, and the surface roughness of the ceramic coating is less likely to be increased.

The electrolyte used in the electrolysis may be, for example, an electrolyte containing zirconium oxide. Use of the electrolyte according to the present invention is preferable.

When the electrolyte containing zirconium oxide is used, zirconium oxide will be incorporated in the coating, and the zirconium oxide will suppress growth of the crystal grain of the oxide of the metal element constituting the metal substrate and formation of compact surface is facilitated. Incorporation of the zirconium oxide as the tetragonal zirconium oxide and/or the cubic zirconium oxide contributes for the excellent mechanical properties including the fracture toughness of the coating.

The method for coating a metal with a ceramic coating, the electrolyte for coating a metal with a ceramic coating, the ceramic coating, and the metal material of the present invention are not limited for their application.

For example, when the present invention is used for providing a ceramic coating with sufficient hardness on a metal substrate comprising an aluminum alloy or magnesium alloy having an insufficient hardness, the resulting material can be used for a sliding member which could not have been produced by using such metal substrate having an insufficient hardness. Examples of such members include inner surface of an aluminum engine cylinder, piston, shaft, rotary compressor member, pump member, agitator blade, valve, cam, shaft, screw, and wire.

In view of the excellent corrosion resistance and resistance to chipping, they are well adapted for use in magnesium wheel, engine cover, and the like.

In view of the chemical stability of the surface and good degassing properties, they can be favorably used, for example, for the inner wall of the chamber in the semiconductor production system.

In consideration of the heat dissipation properties and heat resistance, they are suitable for use in gas turbine, heat sink, aluminum printed circuit board, mold, insulating coil, and the like.

Since zirconium oxide has good ion conductivity, they are well adapted for use in fuel cell, oxygen sensor, and exhaust gas catalyst.

EXAMPLES

Next, the present invention is described in further detail by referring to the Examples which by no means limit the scope of the present invention.

1. Formation of ceramic coating

(Example 1)

Electrolysis was conducted for 10 minutes by bipolar electrolysis using a magnesium die cast alloy plate (a plate of JIS AZ91D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.

The electrolyte used was the one prepared by adding 8.6 g/L of ammonium dihydrogenphosphate and 1.2 g/L (in terms of zirconium oxide) of zirconium oxide particles (a zirconium oxide sol dispersed in water manufactured by Daiichi Kigenso Kagaku Kogyo Co., Ltd. having an average particle size of 0.07 μm, monoclinic crystal) to water, and adjusting the pH to 12.8 by using ammonia solution and potassium hydroxide.

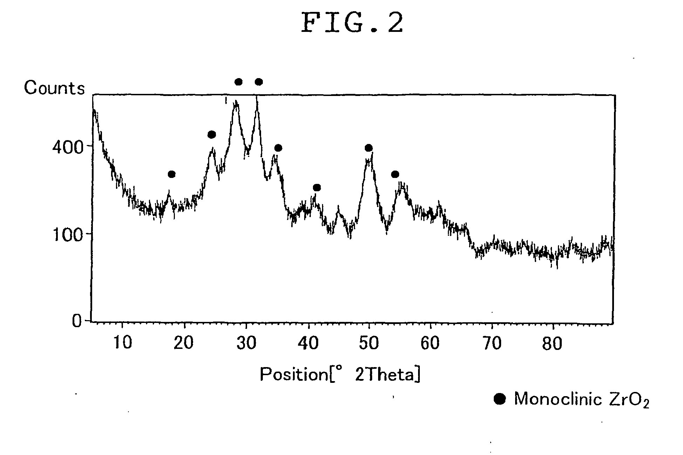

The zirconium oxide sol dispersed in water used in the electrolyte was collected on a filter paper, and the zirconium oxide was evaluated for its crystal system by thin film method using an X-ray diffractometer. The results are shown in FIG. 2. As seen from FIG. 2, the zirconium oxide in the zirconium oxide sol dispersed in water was monoclinic.

The electrolyte had an electric conductivity of 2 S/m, and a ζ potential of -23 mV.

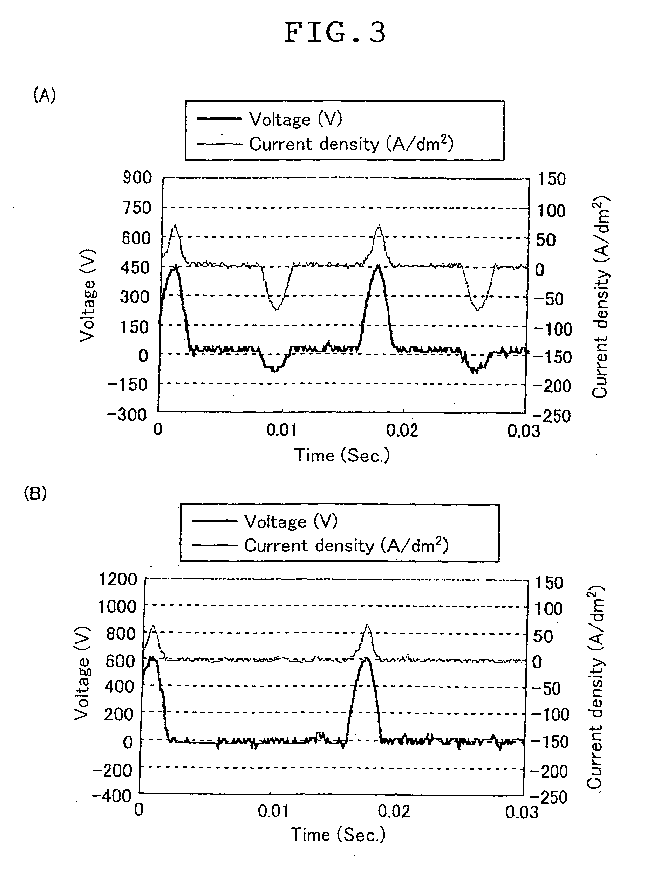

A waveform comprising a pulse wave having a sinusoidal waveform with a positive peak value of 430 V and a negative peak value of 110 overlaid on a direct current component of 20 V (maximum voltage, 450 V; minimum voltage, -90V) was used. FIG. 3(A) shows the results of monitoring the voltage and the current density during the electrolysis.

(Example 2)

Electrolysis was conducted for 10 minutes by bipolar electrolysis using a magnesium die cast alloy plate (a plate of JIS AZ91D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.

The electrolyte used was the one prepared by adding 8.6 g/L of ammonium dihydrogenphosphate and 6 g/L (in terms of zirconium oxide) of zirconium oxide particles (a zirconium oxide sol dispersed in water manufactured by Daiichi Kigenso Kagaku Kogyo Co., Ltd., having an average particle size of 0.07 $\mu$m; monoclinic crystal) to water, and adjusting the pH to 12.7 by using ammonia solution and sodium hydroxide.

The electrolyte had an electric conductivity of 1.8 S/m, and a ζ potential of -25 mV.

The waveform used was the same as the one used in Example 1.

(Example 3)

Electrolysis was conducted for 5 minutes by unipolar electrolysis using a magnesium die cast alloy plate (a plate of JIS AZ31D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.

The electrolyte used was the one prepared by adding 6 g/L (in terms of zirconium oxide) of zirconium oxide particles (a zirconium oxide sol dispersed in water manufactured by Daiichi Kigenso Kagaku Kogyo Co., Ltd. having an average particle size of 0.07 $\mu$m; monoclinic crystal) to water, and adjusting the pH to 12.5 by using ammonia and lithium hydroxide.

The electrolyte had an electric conductivity of 1.85 S/m, and a ζ potential of -27 mV.

A pulse wave having a sinusoidal waveform with a positive peak value of 600 V (maximum voltage, 600 V; minimum voltage, 0 V) was used. FIG. 3(B) shows the results of monitoring the voltage and the current density during the electrolysis.

(Example 4)

Electrolysis was conducted for 20 minutes by bipolar electrolysis using a magnesium alloy plate (a plate of JIS LA41 series) a having a surface area of 1 dm$^2$ for the working electrode and a stainless steel plate for the counter electrode to form a coating on the magnesium alloy plate. When the surface of the working electrode was observed during the electrolysis, light emission by glow discharge and arc discharge was observed.

The electrolyte used was the one prepared by adding 0.4 g/L of potassium dihydrogenphosphate, 0.9 g/L (in terms of zirconium oxide) of zirconium oxide particles (having an average particle size of 0.9 $\mu$m, monoclinic crystal), and 7 g/L of sodium tangstate to water (Y/X = 7.8), and adjusting the pH to 10.7 by using ammonia and potassium hydroxide.

The electrolyte had an electric conductivity of 0.35 S/m, and a ζ potential of -8 mV.

A waveform comprising a pulse wave having a sinusoidal waveform with a positive peak value of 570 V and a negative peak value of -130 overlaid on a direct current component of 30 V (maximum voltage, 600 V; minimum voltage, -100 V) was used.

(Example 5)

Electrolysis was conducted for 10 minutes by bipolar electrolysis using a magnesium die cast alloy plate (a plate of JIS AZ31D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.

The electrolyte used was the one prepared by adding 12.5 g/L of trisodium phosphate, 6 g/L (in terms of zirconium oxide) of zirconium oxide particles (having an average particle size of 0.06 $\mu$m, amorphous), and 0.8 g/L (in terms of titanium oxide) of titanium oxide particles (a sol comprising titanium oxide dispersed in water manufactured by Nippon Perkerizing Co.,Ltd. having an average particle size of 0.14 $\mu$m, anatase structure) to water (Y/X = 0.13), and adjusting the pH to 12.3 by using ammonia solution and potassium hydroxide.

The electrolyte had an electric conductivity of 1.9 S/m, and a ζ potential of -25.5 mV.
The waveform used was the same as the one used in Example 1.

(Example 6)

Electrolysis was conducted for 10 minutes by bipolar electrolysis using a magnesium alloy plate (a plate of ASTM AM60B series) having a surface area of 1 dm$^2$ for the working electrode and a stainless steel plate for the counter electrode to form a coating on the magnesium alloy plate. When the surface of the working electrode was observed during the electrolysis, light emission by glow discharge and arc discharge was observed.
The electrolyte used was the one prepared by adding 9.5 g/L of sodium phosphite, 6 g/L (in terms of zirconium oxide) of zirconium oxide particles (having an average particle size of 0.1 μm, amorphous), and 4 g/L (in terms of titanium oxide) of titanium oxide particles (a sol comprising titanium oxide dispersed in water manufactured by Nippon Perkerizing Co.,Ltd. having an average particle size of 0.1 μm, amorphous) to water (Y/X = 0.67), and adjusting the pH to 12.2 by using ammonia solution and potassium hydroxide.
The electrolyte had an electric conductivity of 2.8 S/m, and a ζ potential of -7 mV.
The waveform used was the same as the one used in Example 1.

(Example 7)

Electrolysis was conducted for 10 minutes by bipolar electrolysis using a magnesium alloy plate (a plate of JIS ZK61A series) having a surface area of 1 dm$^2$ for the working electrode and a stainless steel plate for the counter electrode to form a coating on the magnesium alloy plate. When the surface of the working electrode was observed during the electrolysis, light emission by glow discharge and arc discharge was observed.
The electrolyte used was the one prepared by adding 106 g/L of sodium hypophosphite, and 6 g/L (in terms of zirconium oxide) of zirconium oxide particles (a zirconium oxide sol dispersed in water manufactured by Daiichi Kigenso Kagaku Kogyo Co., Ltd. having an average particle size of 0.07 μm; monoclinic crystal), and adjusting the pH to 8.3 by using ammonia solution and sodium hydroxide.
The electrolyte had an electric conductivity of 10.5 S/m, and a ζ potential of -19 mV.
A pulse wave having a rectangular waveform with a positive peak value of 600 V and a negative peak value of -100 (maximum voltage, 600 V; minimum voltage, -100 V) was used.

(Example 8)

Electrolysis was conducted for 10 minutes by bipolar electrolysis using a magnesium die cast alloy plate (a plate of JIS AZ91D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.
The electrolyte used was the one prepared by adding 13.3 g/L of sodium pyrophosphate, 9.5 g/L of phenol, and 2.5 g/L (in terms of zirconium oxide) of zirconium oxide particles (a zirconium oxide sol dispersed in water manufactured by Daiichi Kigenso Kagaku Kogyo Co., Ltd. having an average particle size of 0.07 μm, monoclinic crystal), and adjusting the pH to 12.7 by using morpholine and sodium hydroxide.
The electrolyte had an electric conductivity of 3.1 S/m, and a ζ potential of -10 mV.
The waveform used was the same as the one used in Example 1.

(Example 9)

Electrolysis was conducted for 10 minutes by bipolar electrolysis using a magnesium die cast alloy plate (a plate of JIS AZ91D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.
The electrolyte used was the one prepared by adding 17 g/L of ammonium dihydrogenphosphate and 185 g/L (in terms of zirconium oxide) of zirconium oxide particles (a zirconium oxide sol dispersed in water manufactured by Daiichi Kigenso Kagaku Kogyo Co., Ltd. having an average particle size of 0.07 μm, monoclinic crystal) to water, and adjusting the pH to 12.7 by using ammonia solution and sodium hydroxide.
The electrolyte had an electric conductivity of 3.6 S/m, and a ζ potential of -20 mV.
The waveform used was the same as the one used in Example 1.

(Example 10)

Electrolysis was conducted for 45 minutes by bipolar electrolysis using a magnesium die cast alloy plate (a plate of JIS AZ91D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.
The electrolyte used was the one prepared by adding 31 g/L of sodium hexametaphosphate, 6 g/L (in terms of zirconium oxide) of zirconium oxide particles (having an average particle size of 0.05 $\mu$m, monoclinic crystal), and 48.5 g/L of potassium zirconium carbonate to water (Y/X = 8.1), and adjusting the pH to 12.0 by using ammonia solution and tetramethylammonium hydroxide.
The electrolyte had an electric conductivity of 5.9 S/m, and a $\zeta$ potential of -5 mV.
A pulse wave having a rectangular waveform with a positive peak value of 370 V (maximum voltage, 370 V; minimum voltage, 0 V) was used.

(Example 11)

Electrolysis was conducted for 10 minutes by bipolar electrolysis using a magnesium alloy plate (a plate of JIS AM100A series) having a surface area of 1 dm$^2$ for thy working electrode and a stainless steel plate for the counter electrode to form a coating on the magnesium alloy plate. When the surface of the working electrode was observed during the electrolysis, light emission by glow discharge and arc discharge was observed.
The electrolyte used was the one prepared by adding 8.6 g/L of ammonium dihydrogenphosphate, 2 g/L of calcium carbonate, and 1.2 g/L (in terms of zirconium oxide) of zirconium oxide particles (a zirconium oxide sol dispersed in water manufactured by Daiichi Kigenso Kagaku Kogyo Co., Ltd. having an average particle size of 0.07 $\mu$m, monoclinic crystal) to water (Y/X = 1.67), and adjusting the pH to 12.9 by using ammonia solution and potassium hydroxide.
The electrolyte had an electric conductivity of 2.2 S/m, and a $\zeta$ potential of -21 mV.
The waveform used was the same as the one used in Example 1.

(Example 12)

Electrolysis was conducted for 10 minutes by bipolar electrolysis using a magnesium die cast alloy plate (a plate of JIS AZ91D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.
The electrolyte used was the one prepared by adding 17 g/L of ammonium tripolyphosphate, 70 g/L of bismuth oxide, and 8 g/L (in terms of zirconium oxide) of zirconium oxide particles (a zirconium oxide sol dispersed in water manufactured by Daiichi Kigenso Kagaku Kogyo Co., Ltd. having an average particle size of 0.07 $\mu$m, monoclinic crystal) to water (Y/X = 8.75), and adjusting the pH to 12.7 by using ammonia solution and potassium hydroxide.
The electrolyte had an electric conductivity of 2.15 S/m, and a $\zeta$ potential of -17 mV.
The waveform used was the same as the one used in Example 1.

(Example 13)

Electrolysis was conducted for 10 minutes by bipolar electrolysis by using an aluminum die cast alloy plate (a plate of JIS ADC12 series) having a surface area of 1 dm$^2$ for the working electrode and a stainless steel plate for the counter electrode to form a coating on the aluminum die cast alloy plate. When the surface of the working electrode was observed during the electrolysis, light emission by glow discharge and arc discharge was observed.
The electrolyte used was the one prepared by adding 14.6 g/L of sodium pyrophosphate and 6 g/L (in terms of zirconium oxide) of zirconium oxide particles (a zirconium oxide sol dispersed in water manufactured by Daiichi Kigenso Kagaku Kogyo Co., Ltd. having an average particle size of 0.07 $\mu$m, monoclinic crystal) to water (pH 10.2).
The electrolyte had an electric conductivity of 1.3 S/m, and a $\zeta$ potential of -15.8 mV.
A waveform comprising a pulse wave having a rectangular waveform with a positive peak value of 490 V and a negative peak value of -110 overlaid on a direct current component of 10 V (maximum voltage, 500 V; minimum voltage, -100 V) was used.

(Example 14)

Electrolysis was conducted for 10 minutes by bipolar electrolysis using an aluminum die cast alloy plate (a plate of JIS ADC12 series) having a surface area of 1 dm$^2$ for the working electrode and a stainless steel plate for the counter electrode to form a coating on the aluminum die cast alloy plate. When the surface of the working electrode was observed during the electrolysis, light emission by glow discharge and arc discharge was observed.

The electrolyte used was the one prepared by adding 4.7 g/L of potassium phosphite and 6 g/L (in terms of zirconium oxide) of zirconium oxide particles (a zirconium oxide sol dispersed in water manufactured by Daiichi Kigenso Kagaku Kogyo Co., Ltd. having an average particle size of 0.07 $\mu$m, monoclinic crystal), and 1.6 g/L of potassium zirconium carbonate to water (Y/X = 0.27), and adjusting the pH to 10.8 by adding ammonia solution.

The electrolyte had an electric conductivity of 1.5 S/m, and a $\zeta$ potential of -12.5 mV.

The waveform used was the same as the one used in Example 1.

(Example 15)

Electrolysis was conducted for 10 minutes by unipolar electrolysis using an aluminum alloy plate (a plate of JIS 2000 series) having a surface area of 1 dm$^2$ for the working electrode and a stainless steel plate for the counter electrode to form a coating on the aluminum alloy plate. When the surface of the working electrode was observed during the electrolysis, light emission by glow discharge and arc discharge was observed.

The electrolyte used was the one prepared by adding 14.6 g/L of sodium pyrophosphate, 6 g/L (in terms of zirconium oxide) of zirconium oxide particles (average particle size of 0.05 $\mu$m, monoclinic crystal), and 30 g/L of zirconium ammonium carbonate to water (Y/X = 5) (pH 9.5).

The electrolyte had an electric conductivity of 7.8 S/m, and a $\zeta$ potential of -3 mV.

A pulse wave having a triangular waveform with a positive peak value of 360 V (maximum voltage, 360 V; minimum voltage, 0 V) was used.

(Example 16)

Electrolysis was conducted for 10 minutes by bipolar electrolysis by using an aluminum alloy plate (a plate of JIS 6000 series) having a surface area of 1 dm$^2$ for the working electrode and a stainless steel plate for the counter electrode to form a coating on the aluminum alloy plate. When the surface of the working electrode was observed during the electrolysis, light emission by glow discharge and arc discharge was observed.

The electrolyte used was the one prepared by adding 6 g/L (in terms of zirconium oxide) of zirconium oxide particles (average particle size of 0.01 $\mu$m, tetragonal crystal) and 3.4 g/L of ammonium dihydrogenphosphate to water, and adjusting the pH to 11.2 by using ammonia solution and sodium hydroxide.

The electrolyte had an electric conductivity of 1.8 S/m, and a $\zeta$ potential of -27 mV.

The waveform used was the same as the one used in Example 1.

(Example 17)

Electrolysis was conducted for 10 minutes by bipolar electrolysis by using an aluminum alloy plate (a plate of JIS 5000 series) having a surface area of 1 dm$^2$ for the working electrode and a stainless steel plate for the counter electrode to form a coating on the aluminum alloy plate. When the surface of the working electrode was observed during the electrolysis, light emission by glow discharge and arc discharge was observed.

The electrolyte used was the one prepared by adding 11.7 g/L of triammonium phosphate, 1.2 g/L (in terms of zirconium oxide) of zirconium oxide particles (average particle size of 0.075 $\mu$m, monoclinic crystal), and 0.8 g/L (in terms of titanium oxide) of titanium oxide particles (a sol comprising titanium oxide dispersed in water manufactured by Nippon Perkerizing Co.,Ltd. having an average particle size of 0.07 $\mu$m, anatase structure) to water (Y/X = 0.67) (pH 10.9).

The electrolyte had an electric conductivity of 2.3 S/m, and a $\zeta$ potential of -12 mV.

The waveform used was the same as the one used in Example 1.

(Example 18)

Electrolysis was conducted for 10 minutes by unipolar electrolysis using an aluminum alloy plate (a plate of JIS 5000 series) having a surface area of 1 dm$^2$ for the working electrode and a stainless steel plate for the counter electrode to form a coating on the aluminum alloy plate. When the surface of the working electrode was observed during the electrolysis, light emission by glow discharge and arc discharge was observed.

The electrolyte used was the one prepared by adding 14.6 g/L of sodium pyrophosphate, 6 g/L (in terms of zirconium oxide) of zirconium oxide particles (having an average particle size of 0.075 $\mu$m, monoclinic crystal), and 10.5 g/L of potassium hexacyanoferrate (II) trihydrate to water (Y/X = 1.75), and adjusting the pH to 13.3 by using potassium hydroxide.

The electrolyte had an electric conductivity of 5.5 S/m, and a $\zeta$ potential of -35 mV.

A pulse wave having a sinusoidal waveform with a positive peak value of 520 V (maximum voltage, 520 V; minimum voltage, 0 V) was used.

(Example 19)

Electrolysis was conducted for 10 minutes by bipolar electrolysis using an aluminum die cast alloy plate (a plate of JIS ADC12 series) having a surface area of 1 dm$^2$ for the working electrode and a stainless steel plate for the counter electrode to form a coating on the aluminum die cast alloy plate. When the surface of the working electrode was observed during the electrolysis, light emission by glow discharge and arc discharge was observed.

The electrolyte used was the one prepared by adding 6.5 g/L of sodium citrate, 6 g/L (in terms of zirconium oxide) of zirconium oxide particles (having an average particle size of 0.05 $\mu$m, monoclinic crystal), and 3.2 g/L of cerium acetate to water (Y/X = 0.53), and adjusting the pH to 7.6 by using oxalic acid .

The electrolyte had an electric conductivity of 2.7 S/m, and a $\zeta$ potential of -5 mV.

A pulse wave having a sinusoidal waveform with a positive peak value of 450 V and a negative peak value of -100 (maximum voltage, 450 V; minimum voltage, -100 V) was used.

(Example 20)

Electrolysis was conducted for 10 minutes by bipolar electrolysis using a magnesium die cast alloy plate (a plate of JIS AZ91D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.

The electrolyte used was the one prepared by adding 8.5 g/L of ammonium dihydrogenphosphate, 6.2 g/L (in terms of zirconium oxide) of zirconium oxide particles (having an average particle size of 0.05 $\mu$m, monoclinic crystal), and 1.5 g/L of sodium silicate to water (Y/X = 0.24), and adjusting the pH to 12.7 by using ammonia solution and potassium hydroxide.

The electrolyte had an electric conductivity of 2.3 S/m, and a $\zeta$ potential of -22 mV.

The waveform used was the same as the one used in Example 1.

(Example 21)

Electrolysis was conducted for 10 minutes by unipolar electrolysis using an aluminum die cast alloy plate (a plate of JIS ADC12 series) having a surface area of 1 dm$^2$ for the working electrode and a stainless steel plate for the counter electrode to form a coating on the aluminum die cast alloy plate. When the surface of the working electrode was observed during the electrolysis, light emission by glow discharge and arc discharge was observed.

The electrolyte used was the one prepared by adding 30 g/L of sodium pyrophosphate, 20 g/L (in terms of zirconium oxide) of zirconium oxide particles (a zirconium oxide sol dispersed in water manufactured by Daiichi Kigenso Kagaku Kogyo Co., Ltd. having an average particle.size of 0.07 $\mu$m, monoclinic crystal), and 70 g/L (in terms of SiO$_2$) of colloidal silica to water (Y/X = 3.5), and adjusting the pH to 9.5 by using ammonia solution and potassium hydroxide.

The electrolyte had an electric conductivity of 2.9 S/m, and a $\zeta$ potential of -3 mV.

A pulse wave having a rectangular waveform with a positive peak value of 390 V (maximum voltage, 390 V; minimum voltage, 0 V) was used.

(Comparative Example 1)

Electrolysis was conducted for 10 minutes by bipolar electrolysis using a magnesium die cast alloy plate (a plate of JIS AZ91D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.

The electrolyte used was the one prepared by adding 8.6 g/L of ammonium dihydrogenphosphate to water, and adjusting the pH to 12.7 by using ammonia solution and potassium hydroxide.

The electrolyte had an electric conductivity of 1.9 S/m, and the $\zeta$ potential could not be measured.

The waveform used was the same as the one used in Example 1.

(Comparative Example 2)

Electrolysis was conducted for 10 minutes by bipolar electrolysis using a magnesium die cast alloy plate (a plate of JIS AZ91D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.

The electrolyte used was the one prepared by adding 6.6 g/L of ammonium hypophosphite and 1.2 g/L (in terms of zirconium oxide) of zirconium oxide particles (average particle size 1.8 $\mu$m, monoclinic crystal) to water, and adjusting the pH to 12.8 by using ammonia solution and potassium hydroxide.

When the electrolyte was allowed to stand, the particles precipitated and the electrolyte could no longer retain its dispersion state.

The electrolyte had an electric conductivity of 1.8 S/m, and a $\zeta$ potential of -13.7 mV.

The waveform used was the same as the one used in Example 1.

(Comparative Example 3)

Electrolysis was conducted for 10 minutes by bipolar electrolysis using a magnesium die cast alloy plate (a plate of JIS AZ31D series) having a surface area of 1 dm$^2$ for the working electrode and a stainless steel plate for the counter electrode to form a coating on the magnesium die cast alloy plate. When the surface of the working electrode was observed during the electrolysis, light emission by glow discharge and arc discharge was observed.

The electrolyte used was the one prepared by adding 8.2 g/L of trisodium phosphate and 0.8 g/L of sodium aluminate to water, and adjusting the pH to 12.7 by using ammonia solution and potassium hydroxide.

The electrolyte had an electric conductivity of 1.2 S/m and the $\zeta$ potential could not be measured.

The waveform used was the same as the one used in Example 1.

(Comparative Example 4)

Electrolysis was conducted for 5 minutes by unipolar electrolysis by using an magnesium alloy plate (a plate of JIS AM60B series) having a surface area of 1 dm$^2$ for the working electrode and a stainless steel plate for the counter electrode to form a coating on the magnesium alloy plate. When the surface of the working electrode was observed during the electrolysis, light emission by glow discharge and arc discharge was observed.

The electrolyte used was the one prepared by adding 2.4 g/L of sodium silicate and 1.3 g/L of potassium fluoride to water, and adjusting the pH to 12.8 by using ammonia solution and sodium hydroxide.

The electrolyte had an electric conductivity of 1.9 S/m, and the $\zeta$ potential could not be measured.

The waveform used was the same as the one used in Example 3.

(Comparative Example 5)

Electrolysis was conducted for 10 minutes by bipolar electrolysis by using a magnesium die cast alloy plate (a plate of JIS AZ91D series) having a surface area of 1 dm$^2$ for the working electrode and a stainless steel plate for the counter electrode to form a coating on the magnesium die cast alloy plate. When the surface of the working electrode was observed during the electrolysis, no light emission by glow discharge and arc discharge was observed.

The electrolyte used was the one prepared by adding 0.15 g/L of tetrasodium hydroxy ethylidene diphosphonate and 0.4 g/L (in terms of zirconium oxide) of zirconium oxide particles (a zirconium oxide sol dispersed in water manufactured by Daiichi Kigenso Kagaku Kogyo Co., Ltd. having an average particle size of 0.07 $\mu$m, monoclinic crystal) to water, and adjusting the pH to 9.7 by using ammonia solution.

The electrolyte had an electric conductivity of 0.07 S/m, and a $\zeta$ potential of -7.7 mV.

The source of the zirconium oxide particles was the same as those used in Example 1.

The waveform used was the same as the one used in Example 1.

(Comparative Example 6)

Electrolysis was conducted for 30 minutes by bipolar electrolysis using an aluminum alloy plate (a plate of JIS 2000 series) having a surface area of 1 dm$^2$ for the working electrode and a stainless steel plate for the counter electrode to form a coating on the aluminum alloy plate. When the surface of the working electrode was observed during the electrolysis, light emission by glow discharge and arc discharge was observed.

The electrolyte used was the one prepared by adding 18.6 g/L of sodium pyrophosphate and 873 g/L (in terms of zirconium oxide) of zirconium oxide particles (having an average particle size of 0.1 $\mu$m, monoclinic crystal) to water, and adjusting the pH to 10.8 by using ammonia solution.

The electrolyte had an electric conductivity of 1.5 S/m and the $\zeta$ potential could not be measured.

The waveform used was the same as the one used in Example 4.

(Comparative Example 7)

Electrolysis was conducted by bipolar electrolysis using an aluminum alloy plate (JIS 1000 series) having a surface area of 1 dm$^2$ for the working electrode and a stainless steel plate for the counter electrode. When the surface of the working electrode was observed during the electrolysis, no light emission by glow discharge and arc discharge was observed.
The electrolyte used was the one prepared by adding 847 g/L of triammonium phosphate and 1.2 g/L (in terms of zirconium oxide) of zirconium oxide particles (a zirconium oxide sol dispersed in water manufactured by Daiichi Kigenso Kagaku Kogyo Co., Ltd. having an average particle size of 0.07 μm, monoclinic crystal) to water, and adjusting pH to 13.2 by using potassium hydroxide.
The electrolyte had an electric conductivity of at least 20 S/m, and the ζ potential could not be measured.
The waveform used was the same as the one used in Example 1.
The electrolysis was stopped because the current value kept increasing and exceeded the allowable limit of the power supply. No coating was formed on the aluminum alloy plate used for the working electrode.

(Comparative Example 8)

Electrolysis was conducted by bipolar electrolysis using a magnesium die cast alloy plate (a plate of JIS AZ91D series) having a surface area of 1 dm$^2$ for the working electrode and a stainless steel plate for the counter electrode. When the surface of the working electrode was observed during the electrolysis, no light emission by glow discharge and arc discharge was observed.
The electrolyte used was the one prepared by adding 17 g/L to ammonium dihydrogenphosphate and 1.2 g/L (in terms of zirconium oxide) of zirconium oxide particles (a zirconium oxide sol dispersed in water manufactured by Daiichi Kigenso Kagaku Kogyo Co., Ltd. having an average particle size of 0.07 μm, monoclinic crystal) to water, and adjusting the pH to 5.5 by using phosphoric acid.
The electrolyte had an electric conductivity of 4.8 S/m, and a ζ potential of 3.5 mV.
The waveform used was the same as the one used in Example 1.
The electrolysis was stopped because the current value kept increasing and exceeded the allowable limit of the power supply. No coating was formed on the magnesium die cast alloy plate used for the working electrode.

(Comparative Example 9)

Electrolysis was conducted by unipolar electrolysis using a magnesium die cast alloy plate (a plate of JIS AZ91D series) having a surface area of 1 dm$^2$ for the working electrode and a stainless steel plate for the counter electrode. When the surface of the working electrode was observed during the electrolysis, no light emission by glow discharge and arc discharge was observed.
The electrolyte used was the same as Example 1.
A pulse wave having a rectangular waveform with a negative peak value of 100 V (maximum voltage, 0 V; minimum voltage, -100 V) was used.
The electrolysis was stopped because the current value kept increasing and exceeded the allowable limit of the power supply. No coating was formed on the magnesium die cast alloy plate used for the working electrode.

(Comparative Example 10)

A magnesium die cast alloy plate (a plate of JIS AZ91D series) which had been anozied in HAE bath (a commercially available product) was used for Comparative Example 10.

(Comparative Example 11)

A magnesium die cast alloy plate (a plate of JIS AZ91D series) which had been anodized in DOW17 bath (a commercially available product) was used for Comparative Example 11.

(Comparative Example 12)

An aluminum alloy plate (a plate of JIS 6000 series) having a hard anodized aluminum film thereon (a commercially available product) was used for Comparative Example 12.

(Comparative Example 13)

Electrolysis was conducted for 10 minutes by bipolar electrolysis using a magnesium die cast alloy plate (a plate of JIS AZ91D series) having a surface area of 1 $dm^2$ for the working electrode and a stainless steel plate for the counter electrode to form a coating on the magnesium die cast alloy plate. When the surface of the working electrode was observed during the electrolysis, light emission by glow discharge and arc discharge was observed.

The electrolyte used was the one prepared by adding 1 g/L (in terms of zirconium oxide) of zirconium oxide particles (having an average particle size of 0.05 $\mu$m, monoclinic crystal), 15 g/L of sodium silicate and 8.6 g/L of ammonium dihydrogenphosphate to water (Y/X = 15), and adjusting the pH to 13.0 by using ammonia solution and potassium hydroxide.

The electrolyte had an electric conductivity of 2.5 S/m, and a $\zeta$ potential of -13 mV.

The waveform used was the same as the one used in Example 1.

In the Examples and Comparative Examples, pH of the electrolyte was measured by a pH meter (PH L-20 manufactured by TOA DKK), electric conductivity was measured by a portable electric conductivity meter (ES-51 manufactured by Horiba Ltd), and $\zeta$ potential was measured by laser Doppler method using $\zeta$ potential measuring apparatus (DELSA440 manufactured by Beckman Coulter). The $\zeta$ potential was measured under the conditions of 25°C and a scattering angle of 17.6°.

The metal substrate and the composition of the electrolyte used in each Example and Comparative Example are shown in Table 1, and the conditions used for the electrolysis are show in Table 2.

2. Evaluation of the ceramic coating

The coatings prepared in Examples 1 to 21 and Comparative Examples 1 to 13 as well as electrolytes used in their preparation were evaluated for the following items.

(1) Observation of the cross-section of the ceramic coating

A section of the coating obtained in Example 1 was prepared for observation of the cross section. The section was observed by an optical microscope, and a photomicrograph was taken at a magnification of 1000.

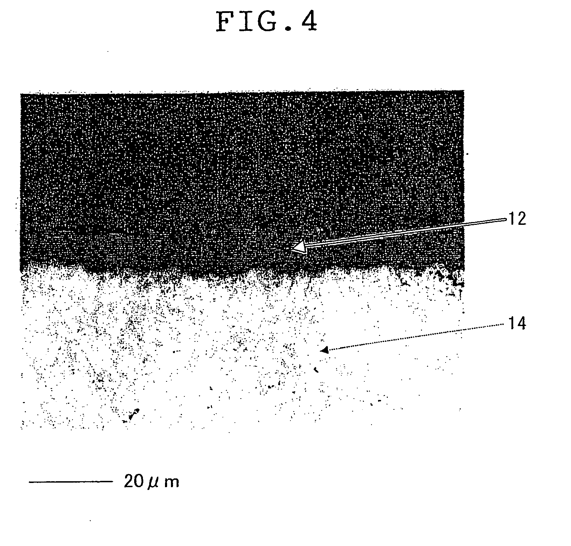

The results are shown in FIG. 4. FIG. 4 demonstrates that the ceramic coating 12 had been formed on the metal substrate (magnesium die cast alloy plate) 14.

(2) Glow discharge optical emission spectrometry

Qualitative analysis of the coating obtained in Examples 1 and 2 was conducted by using glow discharge optical emission spectrometer (manufactured by Horiba Ltd.).

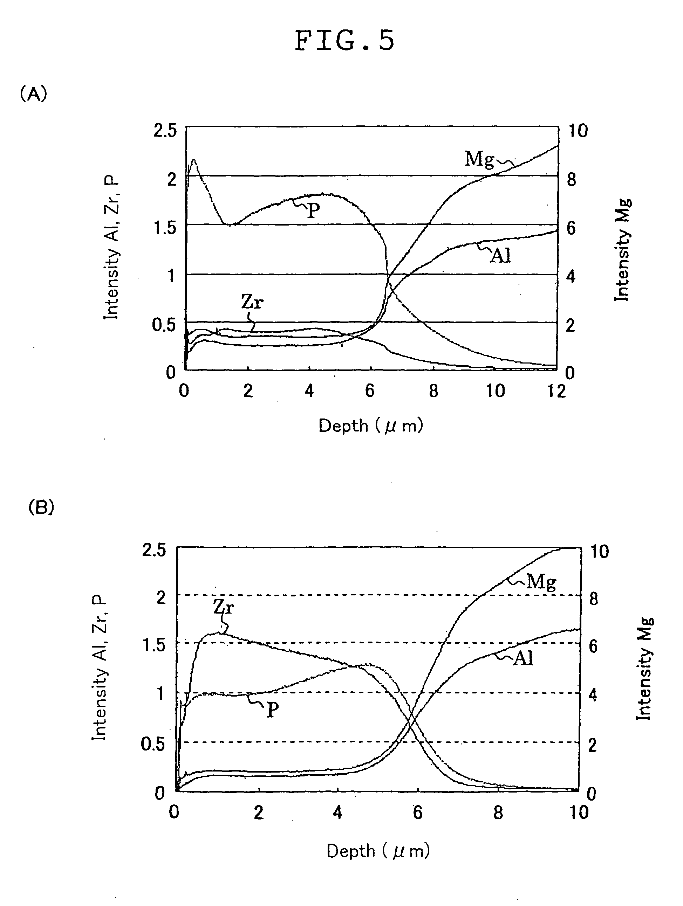

The results are shown in FIG. 5. FIG. 5(A) is a graph showing the result of the qualitative analysis in depth direction of the coating obtained in Example 1. FIG. 5(B) is a graph showing the result of the qualitative analysis in depth direction of the coating obtained in Example 2.

FIGS. 5(A) and 5(B) demonstrate that concentration of the zirconium element gradually decreases near the boundary between the coating and the metal substrate. FIGS. 5(A) and 5(B) also demonstrate that phosphorus element is abundant near the surface of the coating (Example 1) and near the boundary between the coating and the metal substrate (Example 2).

(3) X ray diffractometry

The coatings obtained in Examples 1, 2, and 13 and Comparative Example 1 were evaluated by X ray diffractometry. The X ray diffractometry was conducted by thin film method using a X ray diffractometer manufactured by Phillips.

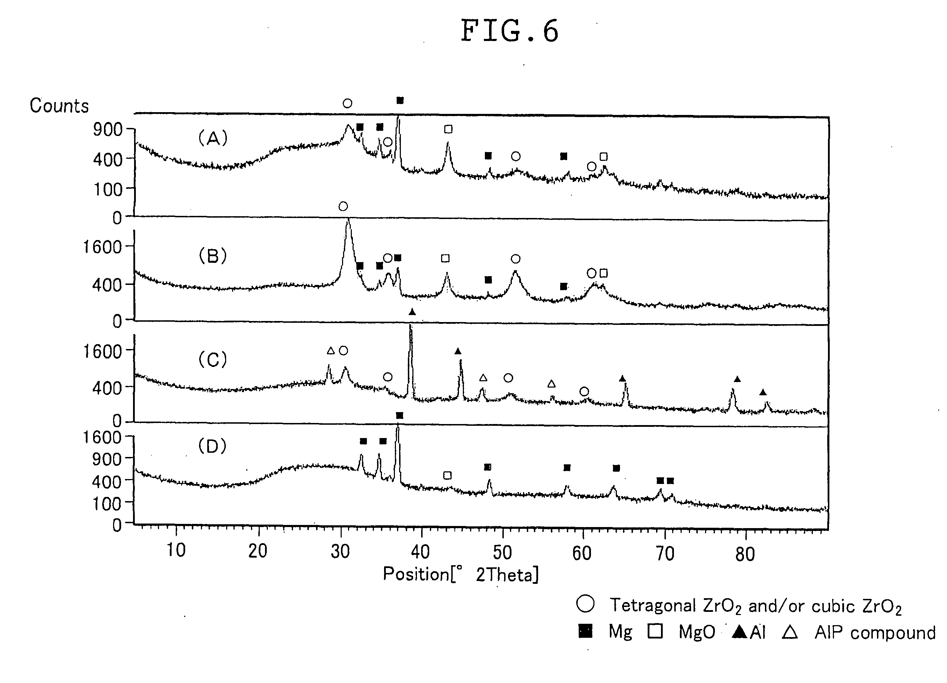

The results are shown in FIG. 6. FIG. 6(A) is a graph showing the X ray diffraction pattern for the coating obtained in Example 1, FIG. 6(B) is a graph showing the X ray diffraction pattern for the coating obtained in Example 2, FIG. 6(C) is a graph showing the X ray diffraction pattern for the coating obtained in Example 13, and FIG. 6(D) is a graph showing the X ray diffraction pattern for the coating obtained in Comparative Example 1.

FIGS. 6(A) to 6(C) demonstrate that the coating produced in Examples 1, 2, and 13 contains tetragonal zirconium oxide and/or cubic zirconium oxide. As demonstrated in FIG. 2, crystal system of the source of the zirconium oxide particles in the electrolyte used in Examples 1, 2, and 13 was monoclinic. This in turn means that the zirconium oxide underwent change in the crystal structure during the electrolysis.

FIG. 6(D) demonstrates that the coating produced in Comparative Example 1 does not contain zirconium oxide.

FIGS. 6(A) and 6(B) demonstrate that, in the pattern obtained by the X-ray diffractometry of the coatings obtained in Examples 1 and 2, relative intensity of the main peak of the tetragonal zirconium oxide and/or the cubic zirconium oxide is higher than 1/4 of the relative strength of the main peak of the magnesium oxide.

As demonstrated in FIGS. 6(A) to 6(C), monoclinic zirconium oxide is not found in the coatings obtained in Examples 1, 2, and 13. Accordingly, proportion (Vm) of the volume of the monoclinic zirconium oxide to total of the volume of the tetragonal zirconium oxide and/or the cubic zirconium oxide and the volume of the monoclinic zirconium oxide calculated by the relation (4) as described above is not more than 0.1.

The coatings obtained in Examples 3 to 12 and 14 to 21 and Comparative Examples 2, 5, 6, and 13 were also evaluated by X-ray diffractometry, and Vm was calculated by the relation (4) as described above from the pattern of the X-ray diffractometry.

Vm of the coating obtain d in Examples 1 to 21 and Comparative Examples 2, 5, 6, and 13 is shown in Table 3.

(4) Observation by transmission electron microscope and energy dispersive X-ray spectrometry

A thin section of the coating obtained in Example 1 was prepared for observation by transmission electron microscope and energy dispersive X-ray spectrometry. It was then found that zirconium oxide particles and magnesium oxide were dispersed in the coating, and that magnesium is present in the zirconium oxide particles.

These results confirmed that zirconium oxide and magnesium oxide are dispersed in the coating formed by the coating method of the present invention, and the metal element constituting the metal substrate is present as solid solution in at least a part of the zirconium oxide particles.

(5) Thickness of the coating

The coatings produced in Examples 1 to 21 and Comparative Examples 1 to 6 and 10 to 13 were measured for their thickness by eddy current coating thickness tester (manufactured by Kett Electric Laboratory).

The results are shown in Table 3.

(6) Centerline average roughness

The surface of the coatings produced in Examples 1 to 21 and Comparative Examples 1 to 6 and 10 to 13 were measured for the center line average roughness by a surface texture and contour measuring instruments manufactured by Tokyo Seimitsu Co., Ltd.

The results are shown in Table 3.

(7) Vickers hardness

Vickers hardness of the surface of the coatings obtained in Examples 1 to 21 and Comparative Examples 1 to 6 and 10 to 13 was measured by a microhardness tester manufactured by Akashi by applying a load of 10 g.

The results are shown in Table 3. The Vickers hardness could not be measured in Comparative Example 5 because the coating was too thin.

(8) Frictional wear test

Frictional wear test was conducted for the coatings obtained in Examples 1 to 21 and Comparative Examples 1 to 6 and 10 to 13 using a reciprocal surface property tester manufactured by Shinto Scientific Co.,Ltd. to measure coefficient of friction and worn area of the counter member, which in turn was used to evaluate attack on the counter member.

In the frictional wear test, a ball of SUJ2 steel having a diameter of 10 mm was used for the counter member. The frictional wear test was conducted by using no lubricant under the stress load of 100 g, slideing speed of 1500 mm/min, and number of reciprocal sliding of 500. The coating after the frictional wear test was measured for the wear depth by a surface texture and contour measuring instruments.

The thus evaluated coefficient of friction, attack on the counter member, and wear depth of the coating are shown in Table 3. The attack on the counter member is indicated by A, B, C, and D in the order from the case of least worn area on the counter member.

In Comparative Example 1, initial coefficient of friction was in the range of 0.25 to 0.3, and the coefficient of friction increased to the range of 0.4 to 0.5 at the number of reciprocal sliding of 400 to 500.

In Comparative Example 2, initial coefficient of friction was in the range of 0.15 to 0.2, and the coefficient of friction increased to the range of 0.3 to 0.4 at the number of reciprocal sliding of 400 to 500.

In Comparative Examples 3 and 4, initial coefficient of friction was already in the range of 0.3 to 0.4.

In Comparative Example 5, initial coefficient of friction was already in the range of 0.5 to 0.6.

In Comparative Example 6, initial coefficient of friction was in the range of 0.15 to 0.2, and the coefficient of friction was in the broad range of 0.3 to 0.6 at the number of reciprocal sliding of 300 to 500.

In Comparative Examples 10 and 11, initial coefficient of friction was in the range of 0.25 to 0.3, and the coefficient of friction increased to the range of 0.4 to 0.5 at the number of reciprocal sliding of 400 to 500.

In Comparative Example 12, initial coefficient of friction was already in the range of 0.5 to 0.6.

In Comparative Example 13, while the coefficient of friction was 0.2 to 0.4, the sample exhibited high attack on the counter member.

Examples 1 to 21 exhibited a coefficient of friction which was lower than that of Comparative Examples 1 to 6 and 10 to 12. The wear depth of Examples 1 to 21 was smaller than that of Comparative Examples 1, 2, 5, 6, and 10 to 13.

(9) Salt spray test

The coatings obtained in Examples 1 to 21 and Comparative Examples 1 to 6 and 10 to 13 were evaluated by salt spray test. Corrosion resistance of the coating was evaluated at 1000 hours after the start of the exposure to the salt spray. The corrosion resistance was evaluated by the outer appearance of the coating in 5 grades from 1 to 5 (the larger figure representing the higher corrosion resistance).

The results are shown in Table 3.

(10) Stability of the electrolyte

Stability of the electrolyte was evaluated by the occurrence of the precipitation after preparing the electrolyte and stopping the stirring. The stability was evaluated D when the precipitation occurred within 1 day; C when the precipitation occurred in 2 to 7 days; B when the precipitation occurred in 8 to 30 days, and A when no precipitation occurred in 30 days .

The results are shown in Table 3.

[Table 1]

Table 1 (1)

| | Metal substrate | Composition of the electrolyte | | | | | | | | |
|---|---|---|---|---|---|---|---|---|---|---|
| | | Amount of $ZrO_2$ (g/L) | Crystal system of $ZrO_2$ | Average particle size of the $ZrO_2$ particles ($\mu$m) | P compound (g/L) | $TiO_2$ or water-soluble Zr (g/L) | Additive (g/L) | pH | Electric conductivity (S/m) | $\zeta$ potential (mV) |
| Ex. 1 | Mg: AZ91D | 1.2 | Monoclinic | 0.07 | $NH_4H_2PO_4$ 8.6 | - | - | 12.8 | 2 | -23 |
| Ex. 2 | Mg: AZ91D | 6 | Monoclinic | 0.07 | $NH_4H_2PO_4$ 8.6 | - | - | 12.7 | 1.8 | -25 |
| Ex. 3 | Mg: AZ31D | 6 | Monoclinic | 0.07 | - | - | - | 12.5 | 1.85 | -27 |
| Ex. 4 | Mg: LA41 | 0.9 | Monoclinic | 0.9 | $KH_2PO_4$ 0.4 | - | $Na_2WO_4$ 7 | 10.7 | 0.35 | -8 |
| Ex. 5 | Mg: AZ31D | 6 | Amorphous | 0.06 | $Na_3PO_4$ 12.5 | Anatase $TiO_2$ 0.8 | - | 12.3 | 1.9 | -25.5 |
| Ex. 6 | Mg: AM60B | 6 | Amorphous | 0.1 | $Na_2PHO_3$ 9.5 | Amorphous $TiO_2$ 4 | - | 12.2 | 2.8 | -7 |
| Ex. 7 | Mg: ZK61A | 6 | Monoclinic | 0.07 | $NaPH_2O_2$ 106 | - | - | 8.3 | 10.5 | -19 |
| Ex. 8 | Mg: AZ91D | 2.5 | Monoclinic | 0.07 | $Na_4P_2O_7$ 13.3 | - | $C_6H_5OH$ 9.5 | 12.7 | 3.1 | -10 |
| Ex. 9 | Mg: AZ91D | 185 | Monoclinic | 0.07 | $NH_4H_2PO_4$ 17 | - | - | 12.7 | 3.6 | -20 |
| Ex. 10 | Mg: AZ91D | 6 | Monoclinic | 0.05 | $(NaPO_3)_6$ 31 | $K_2[Zr(CO_3)_2(OH)_2\}$ 48.5 | - | 12.0 | 5.9 | -5 |

[Table 2]

Table 1 (2)

| | Metal substrate | Composition of the electrolyte | | | | | | | | |
|---|---|---|---|---|---|---|---|---|---|---|
| | | Amount of $ZrO_2$ (g/L) | Crystal system of $ZrO_2$ | Average particle size of the $ZrO_2$ particles ($\mu$m) | P compound (g/L) | $TiO_2$ or water-soluble Zr (g/L) | Additive (g/L) | pH | Electric conductivity (S/m) | $\zeta$ potential (mV) |
| Ex. 11 | Mg: AM100A | 1.2 | Monoclinic | 0.07 | $NH_4H_2PO_4$ 86 | - | $CaCO_3$ 2 | 12.9 | 2.2 | -21 |
| Ex. 12 | Mg: AZ91D | 8 | Monoclinic | 0.07 | $(NH_4)_5P_3O_{10}$ 17 | - | $Bi_2O_3$ 70 | 12.7 | 2.15 | -17 |
| Ex. 13 | Al: ADC12 | 6 | Monoclinic | 0.07 | $Na_4P_2O_7$ 14.6 | - | - | 10.2 | 1.3 | -15.8 |
| Ex. 14 | Al: ADC12 | 6 | Monocle | 0.07 | $K_2PHO_3$ 4.7 | $K_2[Zr(CO_3)_2(OH)_2]$ 1.6 | - | 10.8 | 1.5 | -12.5 |
| Ex. 15 | Al: 2000 | 6 | Monoclinic | 0.05 | $Na_4P_2O_7$ 14.6 | $(NH_4)_2[Zr(CO_3)_2(OH)_2]$ 30 | - | 9.5 | 7.8 | -3 |
| Ex. 16 | Al: 6000 | 6 | Tetragonal | 0.01 | $NH_4H_2PO_4$ 3.4 | - | - | 11.2 | 1.8 | -27 |
| Ex. 17 | Al: 5000 | 1.2 | Monoclinic | 0.075 | $(NH_4)_3PO_4$ 11.7 | Anatase $TiO_2$ 0.8 | - | 10.9 | 2.3 | -12 |
| Ex. 18 | Al: 5000 | 6 | Monoclinic | 0.075 | $Na_4P_2O_7$ 14.6 | - | $K_4[Fe(CN)_6]\cdot3H_2O$ 10.5 | 13.3 | 5.5 | -35 |
| Ex. 19 | Al: ADC12 | 6 | Monoclinic | 0.05 | - | - | $Ce(C_2H_3O_2)_3$ 3.2 | 7.6 | 2.7 | -5 |
| Ex. 20 | Mg: AZ91D | 6.2 | Monoclinic | 0.05 | $NH_4H_2PO_4$ 85 | - | $Na_2SiO_3$ 1.5 | 12.7 | 2.3 | -22 |
| Ex. 21 | Al: ADC12 | 20 | Monoclinic | 0.07 | $Na_4P_2O_7$ 30 | - | $SiO_2$ 70 | 9.5 | 2.9 | -3 |

[Table 3]

Table 1 (3)

|  | Metal substrate | Composition of the electrolyte | | | | | | | | |
|---|---|---|---|---|---|---|---|---|---|---|
|  |  | Amount of $ZrO_2$ (g/L) | Crystal system of $ZrO_2$ | Average particle size of the $ZrO_2$ particles ($\mu$m) | P compound (g/L) | $TiO_2$ or water-soluble $Z_r$ (g/L) | Additive (g/L) | pH | Electric conductivity (S/m) | $\zeta$ potential (mV) |
| Comp. Ex. 1 | Mg: AZ91D | - | - | - | $NH_4H_2PO_4$ 8.6 | - | - | 12.7 | 1.9 | - |
| Comp. Ex. 2 | Mg: AZ91D | 1.2 | Monoclinic | 1.8 | $NaPH_2O_2$ 6.6 | - | - | 12.8 | 1.8 | -13.7 |
| Comp. Ex. 3 | Mg: AZ31D | - | - | - | $Na_3PO_4$ 8.2 | - | $NaAlO_2$ 0.8 | 12.7 | 1.2 | - |
| Comp. Ex. 4 | Mg: AM60B | - | - | - | - | - | $Na_2SiO_3$ 2.4 | 12.8 | 1.9 | - |
| Comp. Ex. 5 | Mg: AZ91D | 0.4 | Monoclinic | 0.07 | HEDP-4Na 0.15 | - | - | 9.7 | 0.07 | -7.7 |
| Comp. Ex. 6 | Al: 2000 | 873 | Monoclinic | 0.1 | $Na_4P_2O_7$ 18.6 | - | - | 10.8 | 1.5 | - |
| Comp. Ex. 7 | Al: 1000 | 1.2 | Monoclinic | 0.07 | $(NH_4)_3PO_4$ 847 | - | - | 13.2 | $\geqq$20 | - |
| Comp. Ex. 8 | Mg: AZ91D | 1.2 | Monoclinic | 0.07 | $NH_4H_2PO_4$ 17 | - | - | 5.5 | 4.8 | 3.5 |
| Comp. Ex. 9 | Mg: AZ91D | 1.2 | Monoclinic | 0.07 | $NH_4H_2PO_4$ 8.6 | - | - | 12.8 | 2 | -23 |
| Comp. Ex. 10 | Mg: AZ91D | Sample: anodized in HAE bath | | | | | | | | |
| Comp. Ex. 11 | Mg: AZ91D | Sample: anodized in DOW17 bath | | | | | | | | |
| Comp. Ex. 12 | Al: 6000 | Sample: hard aluminum oxide coating | | | | | | | | |
| Comp. Ex.13 | Mg: AZ91D | 1 | Monoclinic | 0.05 | $NH_4H_2PO_4$ 8.6 | - | $Na_2SiO_3$ | 13.0 | 2.5 | -13 |

[Table 4]

Table 2 (1)

| | | Conditions used for the electrolysis | | | | |
|---|---|---|---|---|---|---|
| | | Voltage waveform | Maximum voltage (V) | Minimum voltage (V) | Time (min.) | Arc discharge and glow discharge |
| | Ex. 1 | DC voltage + sinusoidal pulse | 450 | -90 | 10 | Yes |
| | Ex. 2 | DC voltage + sinusoidal pulse | 450 | -90 | 10 | Yes |
| | Ex. 3 | Sinusoidal pulse | 600 | 0 | 5 | Yes |
| | Ex. 4 | DC voltage + sinusoidal pulse | 600 | -100 | 20 | Yes |
| | Ex. 5 | DC voltage + sinusoidal pulse | 450 | -90 | 10 | Yes |
| | Ex. 6 | DC voltage + sinusoidal pulse | 450 | -90 | 10 | Yes |
| | Ex. 7 | Rectangular pulse | 600 | -100 | 10 | Yes |
| | Ex. 8 | DC voltage + sinusoidal pulse | 450 | -90 | 10 | Yes |
| | Ex. 9 | DC voltage + sinusoidal pulse | 450 | -90 | 10 | Yes |
| | Ex. 10 | Rectangular pulse | 370 | 0 | 45 | Yes |

[Table 5]

Table 2 (2)

| | | Conditions used for the electrolysis | | | | |
|---|---|---|---|---|---|---|
| | | Voltage waveform | Maximum voltage (V) | Minimum voltage (V) | Time (min.) | Arc discharge and glow discharge |
| | Ex. 11 | DC voltage + sinusoidal pulse | 450 | -90 | 10 | Yes |
| | Ex. 12 | DC voltage + sinusoidal pulse | 450 | -90 | 10 | Yes |
| | Ex. 13 | DC voltage + sinusoidal pulse | 500 | -100 | 10 | Yes |
| | Ex. 14 | DC voltage + sinusoidal pulse | 450 | -90 | 10 | Yes |
| | Ex. 15 | Triangular pulse | 360 | 0 | 10 | Yes |
| | Ex. 16 | DC voltage + sinusoidal pulse | 450 | -90 | 10 | Yes |
| | Ex. 17 | DC voltage + sinusoidal pulse | 450 | -90 | 10 | Yes |
| | Ex. 18 | Sinusoidal pulse | 520 | 0 | 10 | Yes |
| | Ex. 19 | Sinusoidal pulse | 450 | -100 | 10 | Yes |

(continued)

| | | Conditions used for the electrolysis | | | | |
|---|---|---|---|---|---|---|
| | | Voltage waveform | Maximum voltage (V) | Minimum voltage (V) | Time (min.) | Arc discharge and glow discharge |
| | Ex. 20 | DC voltage + sinusoidal pulse | 450 | -90 | 10 | Yes |
| | Ex. 21 | Rectangular pulse | 390 | 0 | 10 | Yes |

[Table 6]

Table 2 (3)

| | Conditions used for the electrolysis | | | | |
|---|---|---|---|---|---|
| | Voltage waveform | Maximum voltage (V) | Minimum voltage (V) | Time (min.) | Arc discharge and glow discharge |
| Comp. Ex. 1 | DC voltage + sinusoidal pulse | 450 | -90 | 10 | Yes |
| Comp. Ex. 2 | DC voltage + sinusoidal pulse | 450 | -90 | 10 | Yes |
| Comp. Ex. 3 | DC voltage + sinusoidal pulse | 450 | -90 | 10 | Yes |
| Comp. Ex. 4 | Sinusoidal pulse | 600 | 0 | 5 | Yes |
| Comp. Ex. 5 | DC voltage + sinusoidal pulse | 450 | -90 | 10 | No |
| Comp. Ex. 6 | DC voltage + sinusoidal pulse | 600 | -100 | 30 | Yes |
| Comp. Ex. 7 | DC voltage + sinusoidal pulse | 450 | -90 | - | No |
| Comp. Ex. 8 | DC voltage + sinusoidal pulse | 450 | -90 | - | No |
| Comp. Ex. 9 | Sinusoidal pulse | 0 | -100 | - | No |
| Comp. Ex. 10 | Sample: anodized in HAE bath | | | | |
| Comp. Ex. 11 | Sample: anodized in DOW17 bath | | | | |
| Comp. Ex. 12 | Sample: hard aluminum oxide coating | | | | |
| Comp. Ex. 13 | DC voltage + sinusoidal pulse | 450 | -90 | 10 | Yes |

[Table 7]

Table 3 (1)

| | $V_m$ | Coating thickness ($\mu$m) | Centerline average roughness ($\mu$m) | Vickers hardness (Hv) | Coefficient of friction | Wear depth ($\mu$m) | Attack on counter member | Corrosion resistance | Stability of the electrolyte |
|---|---|---|---|---|---|---|---|---|---|
| Ex. 1 | ≦0.1 | 9.8 | 0.79 | 484 | 0.20~0.25 | 0.6 | A | 5 | A |
| Ex. 2 | ≦0.1 | 8.7 | 0.97 | 490 | 0.20~0.25 | 0.5 | A | 5 | A |
| Ex. 3 | ≦0.1 | 21.4 | 1.67 | 563 | 0.30~0.40 | 0.0 | B | 3 | A |
| Ex. 4 | 0.3~0.4 | 15.5 | 1.53 | 580 | 0.15~0.20 | 0.5 | A | 3 | B |
| Ex. 5 | ≦0.1 | 10.2 | 0.99 | 497 | 0.20~0.25 | 1.0 | A | 3 | B |
| Ex. 6 | ≦0.1 | 12.5 | 1.11 | 495 | 0.20~0.30 | 0.7 | A | 3 | B |
| Ex. 7 | ≦0.1 | 13.9 | 1.35 | 426 | 0.15~0.20 | 1.0 | A | 4 | A |
| Ex. 8 | ≦0.1 | 13.7 | 1.15 | 487 | 0.20~0.25 | 0.8 | A | 4 | A |
| Ex. 9 | 0.4~0.5 | 12.6 | 0.97 | 593 | 0.15~0.20 | 0.5 | B | 5 | B |
| Ex. 10 | ≦0.1 | 11.8 | 1.03 | 555 | 0.15~0.20 | 0.4 | B | 5 | B |

[Table 8]

Table 3 (2)

| | $V_m$ | Coating thickness ($\mu$m) | Centerline average roughness ($\mu$m) | Vickers hardness (Hv) | Coefficient of friction | Wear depth ($\mu$m) | Attack on counter member | Corrosion resistance | Stability of the electrolyte |
|---|---|---|---|---|---|---|---|---|---|
| Ex. 11 | ≦0.1 | 10.9 | 0.87 | 612 | 0.20~0.25 | 0.3 | B | 5 | C |
| Ex. 12 | ≦0.1 | 11.7 | 0.99 | 510 | 0.25~0.30 | 0.5 | B | 5 | C |
| Ex. 13 | ≦0.1 | 7.5 | 0.65 | 715 | 0.20~0.25 | 0.0 | B | 4 | A |
| Ex. 14 | ≦0.1 | 6.9 | 0.54 | 750 | 0.20~0.25 | 0.2 | B | 3 | B |
| Ex. 15 | ≦0.1 | 15.9 | 1.36 | 643 | 0.15~0.20 | 0.5 | A | 5 | A |
| Ex. 16 | ≦0.1 | 5.8 | 0.44 | 693 | 0.15~0.20 | 0.0 | B | 4 | A |
| Ex. 17 | ≦0.1 | 8.3 | 0.52 | 736 | 0.20~0.25 | 0.0 | B | 4 | B |
| Ex. 18 | ≦0.1 | 9.0 | 0.66 | 683 | 0.25~0.30 | 0.4 | A | 3 | B |
| Ex. 19 | ≦0.1 | 7.5 | 0.51 | 765 | 0.25~0.30 | 0.0 | B | 5 | B |
| Ex.20 | ≦0.1 | 14.0 | 0.82 | 622 | 0.15~0.20 | 0.0 | A | 4 | A |
| Ex. 21 | 0.4~0.5 | 18.5 | 1.48 | 590 | 0.20~0.30 | 1.0 | A | 4 | C |

[Table 9]

Table 3 (3)

| | $V_m$ | Coating thickness (μm) | Centerline average roughness (μm) | Vickers hardness (Hv) | Coefficient of friction | Wear depth (μm) | Attack on counter member | Corrosion resistance | Stability of the electrolyte |
|---|---|---|---|---|---|---|---|---|---|
| Comp. Ex. 1 | - | 9.2 | 0.92 | 400 | 0.40~0.50 | 1.9 | B | 3 | A |
| Comp. Ex. 2 | 0.8~0.9 | 9.9 | 1.87 | 458 | 0.30~0.40 | 1.2 | B | 2 | D |
| Comp. Ex. 3 | - | 10.5 | 0.95 | 596 | 0.30~0.40 | 0.5 | D | 4 | B |
| Comp. Ex. 4 | - | 11.3 | 1.38 | 551 | 0.30~0.40 | 0.6 | C | 4 | B |
| Comp. Ex. 5 | ≦0.1 | 2.3 | 0.36 | - | 0.50~0.60 | 3.5 | B | 1 | A |
| Comp. Ex. 6 | 0.6~0.7 | 12.5 | 1.65 | 405 | 0.30~0.60 | 1.0 | B | 4 | D |
| Comp. Ex. 7 | Coating could not be formed | | | | | | | | |
| Comp. Ex. 8 | Coating could not be formed | | | | | | | | |
| Comp. Ex. 9 | Coating could not be formed | | | | | | | | |
| Comp. Ex. 10 | - | 12.3 | 0.93 | 375 | 0.40~0.50 | 1.3 | B | 4 | A |
| Comp. Ex. 11 | - | 13.2 | 0.94 | 359 | 0.40~0.50 | 1.2 | B | 4 | A |
| Comp. Ex. 12 | - | 15.0 | 1.21 | 460 | 0.50~0.60 | 2.3 | B | 5 | A |
| Comp. Ex. 13 | ≦0.1 | 13.7 | 0.81 | 535 | 0.20~0.40 | 1.4 | C | 4 | A |

As demonstrated in Table 3, the ceramic coatings obtained by using the electrolyte of the present invention according to the coating method of the present invention (Examples 1 to 21) exhibited excellent abrasion resistance, reduced attack on counter member, and high corrosion resistance. The electrolyte was also highly stable. In contrast, the sample prepared by using the electrolyte not containing the zirconium oxide particles (Comparative Example 1) and the sample prepared by using the electrolyte containing the zirconium oxide particles having an excessively large average particle size (Comparative Example 2) were insufficient in the abrasion resistance. The sample prepared by using the electrolyte containing sodium aluminate and not the zirconium oxide particles (Comparative Example 3) and the sample prepared by using the electrolyte containing sodium silicate and not the zirconium oxide particles (Comparative Example 4) exhibited unduly strong attack on the counter member. The samples prepared by the electrolysis with no glow discharge or arc discharge (Comparative Examples 5, 7, 8, and 9) suffered from the problems including low corrosion resistance and non-availability of forming the coating. The samples treated by commercially available anodizing (Comparative Examples 10 to 12) exhibited high coefficient of friction and low abrasion resistance. The sample with excessively high ratio (Y/X) of the content Y of the particular compound to the content X of the zirconium oxide particles (Comparative Example 13) was unfavorable in the attack on the counter member.

INDUSTRIAL APPLICABILITY

As described above, the method for coating a metal with a ceramic coating of the present invention is capable of forming a compact coating on various metal substrates comprising various metals such as magnesium alloy, and the resulting coating has high abrasion resistance, low attack on the counter member, and excellent corrosion resistance.

**Claims**

1. A method for coating a metal with a ceramic coating comprising the step of causing glow discharge and/or arc discharge on a surface of a metal substrate which is used as a working electrode in an electrolyte to electrolytically form the ceramic coating on the surface of the metal substrate, wherein

   the electrolyte contains zirconium oxide particles having an average particle size of up to 1 $\mu$m;
   the electrolyte contains the zirconium oxide particles at a content of X and a compound other than the zirconium oxide which is a compound of at least one element selected from the group consisting of Mg, Al, Si, Ca, Sc, Ti, V, Cr, Mn, Fe, Co, Ni, Cu, Zn, Ga, Ge, Sr, Y, Zr, Nb, Mo, Tc, Ru, Rh, Pd, Ag, In, Sn, Ba, La, Hf, Ta, W, Re, Os, Ir, Pt, Au, Bi, Ce, Nd, Gd, and Ac at a content of Y, and the X and the Y satisfy the following relations (1) to (3):

   $$0.05 \text{ g/L} \le X \le 500 \text{ g/L} \qquad (1),$$

   $$0 \text{ g/L} \le Y \le 500 \text{ g/L} \qquad (2),$$

   and

   $$0 \le Y/X \le 10 \qquad (3);$$

   and the electrolyte has a pH of at least 7.0.

2. The method for coating a metal with a ceramic coating according to claim 1 wherein the electrolyte contains titanium oxide particles having an average particle size of up to 1 $\mu$m.

3. The method for coating a metal with a ceramic coating according to claim 1 or 2 wherein the zirconium oxide in the zirconium oxide particles has an amorphous and/or monoclinic crystal structure.

4. The method for coating a metal with a ceramic coating according to any one of claims 1 to 3 wherein the electrolyte has an electric conductivity of at least 0.05 S/m.

5. The method for coating a metal with a ceramic coating according to any one of claims 1 to 4 wherein the zirconium oxide particles in the electrolyte has a ζ potential of less than 0 mV.

6. The method for coating a metal with a ceramic coating according to any one of claims 1 to 5 wherein the electrolyte contains a water-soluble phosphorus compound.

7. The method for coating a metal with a ceramic coating according to any one of claims 1 to 6 wherein the electrolyte contains a water-soluble zirconium compound.

8. The method for coating a metal with a ceramic coating according to any one of claims 1 to 7 wherein the electrolysis is conducted by unipolar electrolysis with anode polarization or bipolar electrolysis with anode polarization and cathode polarization.

9. The method for coating a metal with a ceramic coating according to any one of claims 1 to 8 wherein the maximum voltage of the voltage waveform used in the electrolysis is at least 300V.

10. The method for coating a metal with a ceramic coating according to claim 8 or 9 wherein the electrolysis causes change in the zirconium oxide crystal structure in the zirconium oxide particles, and this change results in the precipitation of the zirconium oxide in the ceramic coating.

11. The method for coating a metal with a ceramic coating according to claim 10 wherein a part or all of the change in the crystal structure is the change from amorphous and/or monoclinic crystal structure to tetragonal crystal and/or cubic crystal structure.

12. The method for coating a metal with a ceramic coating according to any one of claims 1 to 11 wherein the metal substrate comprises at least one member selected from the group consisting of aluminum, titanium, magnesium, and alloys thereof.

13. An electrolyte for coating a metal with a ceramic coating,
the electrolyte containing zirconium oxide particles having an average particle size of up to 1 μm;
the electrolyte containing the zirconium oxide particles at a content of X and a compound other than the zirconium oxide which is a compound of at least one element selected from the group consisting of Mg, Al, Si, Ca, Sc, Ti, V, Cr, Mn, Fe, Co, Ni, Cu, Zn, Ga, Ge, Sr, Y, Zr, Nb, Mo, Tc, Ru, Rh, Pd, Ag, In, Sn, Ba, La, Hf, Ta, W, Re, Os, Ir, Pt, Au, Bi, Ce, Nd, Gd, and Ac at a content of Y, the X and the Y satisfying the following relations (1) to (3):

$$0.05 \text{ g/L} \leq X \leq 500 \text{ g/L} \qquad (1),$$

$$0 \text{ g/L} \leq Y \leq 500 \text{ g/L} \qquad (2),$$

and

$$0 \leq Y/X \leq 10 \qquad (3);$$

and
the electrolyte having a pH of at least 7.0.

14. The electrolyte for coating a metal with a ceramic coating according to claim 13, the electrolyte containing titanium oxide particles having an average particle size of up to 1 μm at a content of 0.04 to 400 g/L as titanium oxide.

15. The electrolyte for coating a metal with a ceramic coating according to claim 13 or 14 wherein the zirconium oxide in the zirconium oxide particles has an amorphous and/or monoclinic crystal structure.

16. The electrolyte for coating a metal with a ceramic coating according to any one of claims 13 to 15, the electrolyte having an electric conductivity of at least 0.05 S/m.

17. The electrolyte for coating a metal with a ceramic coating according to any one of claims 13 to 16, wherein the zirconium oxide particles in the electrolyte has a $\zeta$ potential of less than 0 mV.

18. The electrolyte for coating a metal with a ceramic coating according to any one of claims 13 to 17, the electrolyte containing a water-soluble phosphorus compound at a content of 0.005 to 150 g/L in terms of phosphorus.

19. The electrolyte for coating a metal with a ceramic coating according to any one of claims 13 to 18, the electrolyte containing a water-soluble zirconium compound at a content of 0.1 to 100 g/L in terms of zirconium.

20. The electrolyte for coating a metal with a ceramic coating according to any one of claims 13 to 19 which is used for forming a ceramic coating on a surface of a metal substrate comprising at least one member selected from the group consisting of aluminum, titanium, magnesium, and alloys thereof.

21. A ceramic coating formed on a metal substrate, said ceramic coating comprising
a matrix layer comprising an amorphous oxide of the metal element constituting the metal substrate, and crystalline oxide of said metal element and zirconium oxide particles in the matrix layer, the zirconium oxide particles containing in at least a part thereof the metal element as solid solution.

22. The ceramic coating according to claim 21 wherein the matrix layer contains titanium oxide particles having an average particle size of up to 1 $\mu$m.

23. The ceramic coating according to claim 21 or 22 wherein concentration of the zirconium element gradually decreases from the side of said surface to the side of said metal substrate.

24. The ceramic coating according to any one of claims 21 to 23 wherein the zirconium oxide in the zirconium oxide particles contains tetragonal and/or cubic crystal structure.

25. The ceramic coating according to any one of claims 21 to 24 wherein relative intensity of the main peak of the tetragonal zirconium oxide and/or the cubic zirconium oxide is at least 1/4 of the relative intensity of the main peak of the oxide of the metal element, when the surface is analyized by X ray diffractometry.

26. The ceramic coating according to any one of claims 21 to 25 wherein ratio of the volume of the monoclinic zirconium oxide to the total of the volume of the tetragonal zirconium oxide and/or the cubic zirconium oxide and the volume of the monoclinic zirconium oxide determined by X ray diffractometry of the surface is up to 0.8.

27. The ceramic coating according to any one of claims 21 to 26 wherein ratio of content of the.phosphorus compound per unit coating thickness in intermediate region other than surface region (the region from the surface to the depth of 1 $\mu$m) and boundary region (the region of 1 $\mu$m from the boundary with the metal substrate) to content of the phosphorus compound per unit coating thickness in the surface region and/or the boundary region is less than 1.

28. The ceramic coating according to any one of claims 21 to 27 wherein the metal substrate comprises at least one member selected from the group consisting of aluminum, titanium, magnesium, and alloys thereof.

29. The ceramic coating produced by the method for coating a metal with a ceramic coating of any one of claims 1 to 12.

30. A metal material comprising a metal substrate and a ceramic coating on the metal substrate, wherein the ceramic coating is the ceramic coating of any one of claims 21 to 29.

FIG.1

# FIG.2

# FIG.3

(A)

(B)

# FIG.4

— 12

— 14

——————— 20 μm

# FIG.5

(A)

(B)

FIG.6

<div align="center">

### INTERNATIONAL SEARCH REPORT

</div>

| | International application No. |
|---|---|
| | PCT/JP2007/067727 |

**A. CLASSIFICATION OF SUBJECT MATTER**
*C25D11/04*(2006.01)i, *C25D11/06*(2006.01)i, *C25D11/26*(2006.01)i, *C25D11/30*(2006.01)i

According to International Patent Classification (IPC) or to both national classification and IPC

**B. FIELDS SEARCHED**

Minimum documentation searched (classification system followed by classification symbols)
C25D11/04, C25D11/06, C25D11/26, C25D11/30

Documentation searched other than minimum documentation to the extent that such documents are included in the fields searched
Jitsuyo Shinan Koho        1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2005/118919 A1 (Nihon Parkerizing Co., Ltd.), | 1,2,4-9, 12-14,16-30 |
| A | 15 December, 2005 (15.12.05), Full text & EP 1818428 A1 | 3,10,11,15 |
| X | JP 2005-521794 A (Isle Coat Ltd.), 21 July, 2005 (21.07.05), Par. No. [0048] & GB 2386907 A        & US 2003/188972 A1 & WO 2003/083181 A2    & NO 200304936 A & AU 2002329410 A1     & EP 1488024 A2 & KR 2004093137 A      & US 6896785 B2 & CN 1623013 A         & GB 2386907 B & AU 2002329410 A8 | 1,2,4-9, 12-14,16-22, 28-30 |

☐ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 12 December, 2007 (12.12.07) | 25 December, 2007 (25.12.07) |

| Name and mailing address of the ISA/ | Authorized officer |
|---|---|
| Japanese Patent Office | |
| Facsimile No. | Telephone No. |

Form PCT/ISA/210 (second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002220697 A
- JP 2006045624 A
- JP 8167543 A
- JP 2004091852 A
- JP 11502567 A
- JP 2000345370 A
- JP 3094077 A

**Non-patent literature cited in the description**

- **Saijo, J. ; Hino, M. et al.** *Hyomen Gijutu,* 2005, vol. 56 (9), 547-551
- **Sakai, K. ; Hino, M. et al.** *Materia,* 2004, vol. 43 (1), 52-54